(19) **Europäisches Patentamt**
**European Patent Office**
**Office européen des brevets**

(11) **EP 3 684 883 B1**

(12) # EUROPEAN PATENT SPECIFICATION

(45) Date of publication and mention
of the grant of the patent:
**03.04.2024  Bulletin 2024/14**

(51) International Patent Classification (IPC):
**C09K 11/02** *(2006.01)*      **B82Y 20/00** *(2011.01)*
**B82Y 40/00** *(2011.01)*      **C09K 11/62** *(2006.01)*

(21) Application number: **18800420.4**

(22) Date of filing: **24.10.2018**

(52) Cooperative Patent Classification (CPC):
**C09K 11/025; C09K 11/62; H10K 50/115;**
B82Y 40/00; H10K 50/15; H10K 50/16

(86) International application number:
**PCT/US2018/057307**

(87) International publication number:
**WO 2019/084135 (02.05.2019 Gazette 2019/18)**

(54) **STABLE INP QUANTUM DOTS WITH THICK SHELL COATING AND METHOD OF PRODUCING THE SAME**

STABILE INP-QUANTENPUNKTE MIT DICKER HÜLLENBESCHICHTUNG UND VERFAHREN ZUR HERSTELLUNG DAVON

POINTS QUANTIQUES STABLES D'INP COMPORTANT UN REVÊTEMENT D'ENVELOPPE ÉPAIS ET PROCÉDÉ POUR LEUR PRODUCTION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **25.10.2017   US 201715793735**

(43) Date of publication of application:
**29.07.2020   Bulletin 2020/31**

(73) Proprietor: **Shoei Chemical Inc.**
**Tokyo 163-0443 (JP)**

(72) Inventors:
• **IPPEN, Christian**
**Sunnyvale**
**California 94086 (US)**
• **JEN-LA PLANTE, Ilan**
**San Jose**
**California 95110 (US)**
• **KAN, Shihai**
**San Jose**
**California 95129 (US)**
• **WANG, Chunming**
**Milpitas**
**California 95038 (US)**
• **GUO, Wenzhuo**
**San Jose**
**California 95125 (US)**
• **CHOW, Yeewah Annie**
**San Jose**
**California 95138 (US)**
• **DOHNER, Emma Rose**
**Redwood City**
**California 94061 (US)**

(74) Representative: **Bandpay & Greuter**
**11 rue Christophe Colomb**
**75008 Paris (FR)**

(56) References cited:
**EP-A1- 3 448 957          EP-A1- 3 448 957**
**WO-A1-2012/035535       WO-A1-2014/209154**
**US-A1- 2014 001 405     US-A1- 2016 225 947**
**US-A1- 2017 066 965**

**Description**

BACKGROUND OF THE INVENTION

Field of the Invention

Highly luminescent nanostructures, particularly highly luminescent quantum dots, comprising a nanocrystal core and thick shells of ZnSe and ZnS, are provided. The nanostructures may have one or more gradient $ZnSe_xS_{1-x}$ monolayers between the ZnSe and ZnS shells, wherein the value of x decreases gradually from the interior to the exterior of the nanostructure. Also provided are methods of preparing the nanostructures comprising a high temperature synthesis method. The thick shell nanostructures of the present invention display increased stability and are able to maintain high levels of photoluminescent intensity over long periods of time. Also provided are nanostructures with increased blue light absorption.

Background Art

Semiconductor nanostructures can be incorporated into a variety of electronic and optical devices. The electrical and optical properties of such nanostructures vary, e.g., depending on their composition, shape, and size. For example, size-tunable properties of semiconductor nanoparticles are of great interest for applications such as light emitting diodes (LEDs), lasers, and biomedical labeling. Highly luminescent nanostructures are particularly desirable for such applications.

To exploit the full potential of nanostructures in applications such as LEDs and displays, the nanostructures need to simultaneously meet five criteria: narrow and symmetric emission spectra, high photoluminescence (PL) quantum yields (QYs), high optical stability, eco-friendly materials, and low-cost methods for mass production. Most previous studies on highly emissive and color-tunable quantum dots have concentrated on materials containing cadmium, mercury, or lead. Wang, A., et al., Nanoscale 7:2951- 2959 (2015). But, there are increasing concerns that toxic materials such as cadmium, mercury, or lead would pose serious threats to human health and the environment and the European Union's Restriction of Hazardous Substances rules ban any consumer electronics containing more than trace amounts of these materials. Therefore, there is a need to produce materials that are free of cadmium, mercury, and lead for the production of LEDs and displays.

Cadmium-free quantum dots based on indium phosphide are inherently less stable than the prototypic cadmium selenide quantum dots. The higher valence and conduction band energy levels make InP quantum dots more susceptible to photooxidation by electron transfer from an excited quantum dot to oxygen, as well as more susceptible to photoluminescence quenching by electron-donating agents such as amines or thiols which can refill the hole states of excited quantum dots and thus suppress radiative recombination of excitons. See, e.g., Chibli, H., et al., "Cytotoxicity of InP/ZnS quantum dots related to reactive oxygen species generation," Nanoscale 3:2552-2559 (2011); Blackburn, J.L., et al., "Electron and Hole Transfer from Indium Phosphide Quantum Dots," J. Phys. Chem. B 709:2625-2631 (2005); and Seimarten, D., et al., "Quenching of Semiconductor Quantum Dot Photoluminescence by a $\pi$-Conjugated Polymer," J. Phys. Chem. B 709: 15927-15933 (2005).

Inorganic shell coatings on quantum dots are a universal approach to tailoring their electronic structure. Additionally, deposition of an inorganic shell can produce more robust particles by passivation of surface defects. Ziegler, J., et al., Adv. Mater. 20:4068- 4073 (2008). For example, shells of wider band gap semiconductor materials such as ZnS can be deposited on a core with a narrower band gap- such as CdSe or InP- to afford structures in which excitons are confined within the core. This approach increases the probability of radiative recombination and makes it possible to synthesize very efficient quantum dots with quantum yields close to unity and thin shell coatings.

Core shell quantum dots that have a shell of a wider band gap semiconductor material deposited onto a core with a narrower band gap are still prone to degradation mechanisms- because a thin shell of less than a nanometer does not sufficiently suppress charge transfer to environmental agents. A thick shell coating of several nanometers would reduce the probability for tunneling or exciton transfer and thus, it is believed that a thick shell coating would improve stability- a finding that has been demonstrated for the CdSe/CdS system.

Regardless of the composition of quantum dots, most quantum dots do not retain their originally high quantum yield after continuous exposure to excitation photons. Elaborate shelling engineering such as the formation of multiple shells and thick shells- wherein the carrier wave functions in the core become distant from the surface of the quantum dot-have been effective in mitigating the photoinduced quantum dot deterioration. Furthermore, it has been found that the photodegradation of quantum dots can be retarded by encasing them with an oxide- physically isolating the quantum dot surface from their environment. Jo, J.-H., et al., J. Alloys Compd. 647:6-13 (2015).

Thick coatings on CdSe/CdS giant shell quantum dots have been found to improve their stability towards environmental agents and surface charges by decoupling the light-emitting core from the surface over several nanometers. A need exists to produce materials that have the improved stability found with thick shell quantum dots but also have the beneficial properties of thin shell quantum dots such as high quantum yield, narrow emission peak width, tunable emission wavelength, and colloidal stability.

It is difficult to retain the beneficial properties of thin shell quantum dots when producing thick shells due to the manifold opportunities for failure and degradation such as: (1) dot precipitation due to increased mass, reduced surface-to-volume ratio, and increased total surface area; (2) irreversible aggregation with shell material bridging dots; (3) secondary nucleation of shell material; (4) relaxation of lattice strain resulting in interface defects; (5) anisotropic shell growth on preferred facets; (6) amorphous shell or non-epitaxial interface; and (7) a broadening of size distribution resulting in a broad emission peak.

The interfaces in these heterogenous nanostructures need to be free of defects because defects act as trap sites for charge carriers and result in a deterioration of both luminescence efficiency and stability. Due to the naturally different lattice spacings of these semiconductor materials, the crystal lattices at the interface will be strained. The energy burden of this strain is compensated by the favorable epitaxial alignment of thin layers, but for thicker layers the shell material relaxes to its natural lattice- creating misalignment and defects at the interface. There is an inherent tradeoff between adding more shell material and maintaining the quality of the material. Therefore, a need exists to find a suitable shell composition that overcomes these problems.

Recent advances have made it possible to obtain highly luminescent plain core nanocrystals. But, the synthesis of these plain core nanocrystals has shown stability and processibility problems and it is likely that these problems may be intrinsic to plain core nanocrystals. Thus, core/shell nanocrystals are preferred when the nanocrystals must undergo complicated chemical treatments- such as for biomedical applications- or when the nanocrystals require constant excitation as with LEDs and lasers. See Li, J. J., et al., J. Am. Chem. Soc. 725: 12567-12575 (2003).

There are two critical issues that must be considered to control the size distribution during the growth of shell materials: (1) the elimination of the homogenous nucleation of the shell materials; and (2) homogenous monolayer growth of shell precursors to all core nanocrystals in solution to yield shell layers with equal thickness around each core nanocrystal. Successive ion layer adsorption and reaction (SILAR) was originally developed for the deposition of thin films on solid substrates from solution baths and has been introduced as a technique for the growth of high-quality core/shell nanocrystals of compound semiconductors.

CdSe/CdS core/shell nanocrystals have been prepared with photoluminescence quantum yields of 20-40% using the SILAR method. Li, J.J., et al., J. Am. Chem. Soc. 725: 12567-12575 (2003). In the SILAR process, the amount of the precursors used for each half-reaction are calculated to match one monolayer coverage for all cores - a technique that requires precise knowledge regarding the surface area for all cores present in the reaction mixture. And, the SILAR process assumes quantitative reaction yields for both half-reactions and thus, inaccuracies in measurements accumulate after each cycle and lead to a lack of control.

The colloidal atomic layer deposition (c-ALD) process was proposed in Ithurria, S., et al., J. Am. Chem. Soc. 134: 18585-18590 (2012) for the synthesis of colloidal nanostructures. In the c-ALD process, either nanoparticles or molecular precursors are sequentially transferred between polar and nonpolar phases to prevent unreacted precursors and byproducts from accumulating in the reaction mixture. The c-ALD process has been used to grow CdS layers on colloidal CdSe nanocrystals, CdSe nanoplatelets, and CdS nanorods. But, the c-ALD process suffers from the need to use phase transfer protocols that introduce exposure to potentially detrimental highly polar solvents such as formamide, N-methyl-formamide, or hydrazine.

It is also known from :

- US2014/0001405 InP/ZnS$_x$Se$_{1-x}$/ZnS nanostructures where 0.25<x<0.75
- Jouranl of Information Display, vol.13, No.2, June 2012, 91-95 : novel multishell system for InP quatum dots;
- WO2014209154 : organic light-emitting element containing quantum dots with modified surface;
- WO2017/189666 : InP quantum dots with shell coating.

A need exists to find a thick shell synthesis method that avoids the failure and degradation opportunities for thick shells. The present invention provides thick shell coating methods applicable to producing cadmium-free quantum dots.

BRIEF SUMMARY OF THE INVENTION

The present invention provides a molded article comprising multi-layered nanostructures which is InP/ZnSe/ZnS core-shell nanostructures wherein at least two of the shells is between 0.7 nm and 3.5 nm.

The method of producing a multi-layered nanostructure comprises:

(a) contacting a nanocrystal core with at least two shell precursors; and

(b) heating (a) at a temperature between about 200 °C and about 310 °C;

to provide a nanostructure comprising at least one shell, wherein at least one shell comprises between 2.5 and 10 monolayers.

The nanocrystal core contacted comprises InP.

In some embodiments, the at least two shell precursors contacted with a nanocrystal core comprises a zinc source. In some embodiments, the zinc source is selected from the group consisting of zinc oleate, zinc hexanoate, zinc octanoate, zinc laurate, zinc palmitate, zinc stearate, zinc dithiocarbamate, or mixtures thereof. In some embodiments, the zinc source is zinc stearate or zinc oleate.

In some embodiments, the at least two shell precursors contacted with a nanocrystal core comprises a selenium source. In some embodiments, the selenium source is selected from the group consisting of trioctylphosphine selenide, tri(n- butyl)phosphine selenide, tri(sec-butyl)phosphine selenide, tri(tert-butyl)phosphine selenide, trimethylphosphine selenide, triphenylphosphine selenide, diphenylphosphine selenide, phenylphosphine selenide, tricyclohexylphosphine selenide, cyclohexylphosphine selenide, 1-octaneselenol, 1-dodecaneselenol, selenophenol, elemental selenium, bis(trimethylsilyl) selenide, and mixtures thereof. In some embodiments, the selenium source is tri(n-butyl)phosphine selenide or trioctylphosphine selenide.

In some embodiments, the molar ratio of the core to the selenium source is between 1 :2 and 1 : 1000. In some embodiments, the molar ratio of the core to the selenium source is between 1:10 and 1 : 1000.

In some embodiments, the at least two shell precursors contacted with a nanocrystal core comprises a sulfur source. In some embodiments, the sulfur source is selected from the group consisting of elemental sulfur, octanethiol, dodecanethiol, octadecanethiol, tributylphosphine sulfide, cyclohexyl isothiocyanate, a-toluenethiol, ethylene trithiocarbonate, allyl mercaptan, bis(trimethylsilyl) sulfide, trioctylphosphine sulfide, and mixtures thereof. In some embodiments, the sulfur source is octanethiol.

In some embodiments, the molar ratio of the core to the sulfur source is between 1 :2 and 1 : 1000. In some embodiments, the molar ratio of the core to the sulfur source is between 1:10 and 1 : 1000.

In some embodiments, the nanocrystal core and the at least one shell material are heated at a temperature between about 250 °C and about 310 °C. In some embodiments, the nanocrystal core and the at least one shell material are heated at a temperature of about 280 °C.

In some embodiments, the heating of the nanocrystal core and the at least one shell material is maintained for between 2 minutes and 240 minutes. In some embodiments, the heating of the nanocrystal core and the at least two shell precursors is maintained for between 30 minutes and 120 minutes.

In some embodiments, the contacting of a nanocrystal core with at least two shell precursors further comprises a solvent. In some embodiments, the solvent is selected from the group consisting of 1-octadecene, 1-hexadecene, 1-eicosene, eicosane, octadecane, hexadecane, tetradecane, squalene, squalane, trioctylphosphine oxide, and dioctyl ether. In some embodiments, the solvent is 1-octadecene.

In some embodiments, the nanocrystal core is an InP nanocrystal, at least one shell comprises ZnS, at least one shell comprises ZnSe, and the heating of the nanocrystal core and the at least two shell precursors is at a temperature between about 250 °C and about 310 °C.

The method of producing a multi-layered nanostructure comprises:

(a) contacting a nanocrystal core with at least two shell precursors;
(b) heating (a) at a temperature between about 200 °C and about 310 °C;
(c) contacting (b) with at least one shell precursor, wherein the at least one shell precursor is different from the shell precursors in (a); and
(d) heating (c) at a temperature between about 200 °C and about 310 °C;

to provide a nanostructure comprising at least two shells, wherein at least one shell comprises between 2.5 and 10 monolayers.

In some embodiments, the at least two shell precursors contacted comprises a zinc source. In some embodiments, the zinc source is selected from the group consisting of zinc oleate, zinc hexanoate, zinc octanoate, zinc laurate, zinc palmitate, zinc stearate, zinc dithiocarbamate, or mixtures thereof. In some embodiments, the zinc source is zinc stearate or zinc oleate.

In some embodiments, the at least two shell precursors contacted comprises a selenium source. In some embodiments, the selenium source is selected from the group consisting of trioctylphosphine selenide, tri(n-butyl)phosphine selenide, tri(sec-butyl)phosphine selenide, tri(tert-butyl)phosphine selenide, trimethylphosphine selenide, triphenylphosphine selenide, diphenylphosphine selenide, phenylphosphine selenide, tricyclohexylphosphine selenide, cyclohexylphosphine selenide, 1-octaneselenol, 1-dodecaneselenol, selenophenol, elemental selenium, bis(trimethylsilyl) selenide, and mixtures thereof. In some embodiments, the selenium source is tri(n-butyl)phosphine selenide or trioctylphosphine selenide.

In some embodiments, the at least two shell precursors contacted comprises a sulfur source. In some embodiments, the sulfur source is selected from the group consisting of elemental sulfur, octanethiol, dodecanethiol, octadecanethiol, tributylphosphine sulfide, cyclohexyl isothiocyanate, a-toluenethiol, ethylene trithiocarbonate, allyl mercaptan, bis(trimethylsilyl) sulfide, trioctylphosphine sulfide, and mixtures thereof. In some embodiments, the sulfur source is octanethiol. [0035] The present invention also provides a multi-layered nanostructure comprising a core and at least two shells, wherein at least two of the shells comprise different shell materials, wherein at least one of the shells comprises between about 2 and about 10 monolayers of shell material, and wherein the nanostructure has a normalized optical density of between about 1.0 and about 8.0.

The multi-layered nanostructure core comprises InP.

In some embodiments, the multi-layered nanostructure comprises at least two shells, wherein at least one of the shells comprises between about 3 and about 8 monolayers of shell material. In some embodiments, the multi-layered nanostructure comprises at least two shells, wherein at least one of the shells comprises between about 3 and about 5 monolayers of shell material.

In some embodiments, the multi-layered nanostructure has a normalized optical density of between about 1.5 and about 8.0. In some embodiments, the multi-layered nanostructure has a normalized optical density of between about 1.8 and about 8.0.

In some embodiments, the multi-layered nanostructure comprises at least two shells, wherein at least one of the shells comprises ZnSe, wherein at least one of the shells comprises between about 3 and about 5 monolayers of shell material, and wherein the nanostructure has a normalized optical density of between about 1.3 and about 8.0.

In an embodiment, in the multi-layered nanostructure of the invention at least one of the shells comprises between about 2 and about 10 monolayers of shell material, at least one of the shells comprises an alloy, and the nanostructure has a normalized optical density of between about 1.0 and about 8.0.

In some embodiments, the multi-layered nanostructure comprises at least two shells, wherein at least one of the shells comprises between about 3 and about 8 monolayers of shell material. In some embodiments, the multi-layered nanostructure comprises at least two shells, wherein at least one of the shells comprises between about 3 and about 5 monolayers of shell material.

In some embodiments, the multi-layered nanostructure has a normalized optical density of between about 1.5 and about 8.0. In some embodiments, the multi-layered nanostructure has a normalized optical density of between about 1.8 and about 8.0.

In some embodiments, the method of producing a multi-layered nanostructure provides a nanostructure having a normalized optical density between about 1.0 and about 8.0.

In some embodiments, the method of producing a multi-layered nanostructure provides a nanostructure having a normalized optical density between about 1.5 and about 8.0. In some embodiments, the method of producing a multi-layered nanostructure provides a nanostructure having a normalized optical density between about 1.8 and about 8.0. In some embodiments, the method of producing a multi-layered nanostructure provides a nanostructure having a normalized optical density between about 1.0 and 8.0.

In some embodiments, the method of producing a multi-layered nanostructure further comprising contacting with at least one additional component.

In some embodiments, the at least one additional component is selected from the group consisting of ZnS, GaN, ZnSe, A1P, CdS, GaP, ZnTe, AlAs, CdSe, AlSb, CdTe, GaAs, Sn, Ge, and InP.

In some embodiments, the at least one additional component is ZnTe.

In some embodiments, the method of producing a multi-layered nanostructure provides a nanostructure having a normalized optical density between about 1.5 and about 8.0.

In some embodiments, the method of producing a multi-layered nanostructure provides a nanostructure having a normalized optical density between about 1.8 and about 8.0.

In some embodiments, the molded article is a light emitting diode.

In some embodiments, the molded article exhibits an external quantum efficiency (EQE) of between about 6% and about 20%.

In some embodiments, the molded article exhibits an EQE of between about 8% and about 20%.

In some embodiments, the molded article has a luminance at 7 volts of between about 3000 $cd/m2$ and about 6000 $cd/m^2$.

In some embodiments, the molded article has a luminance at 7 volts of between about 3500 $cd/m2$ and about 4500 $cd/m^2$.

In some embodiments, the molded article has a solid-state quantum yield of between about 10% and about 50%.

In some embodiments, the molded article has a solid-state quantum yield of between about 30% and about 45%.

The present disclosure also provides a nanostructure molded article comprising:

(a) a first barrier layer;
(b) a second barrier layer; and
(c) InP/ZnSe/ZnS core-shell nanostructure as multi-layered nanostructure, wherein the thickness of at least two of the shells is between 0.7 nm and 3.5 nm.

BRIEF DESCRIPTION OF THE DRAWINGS

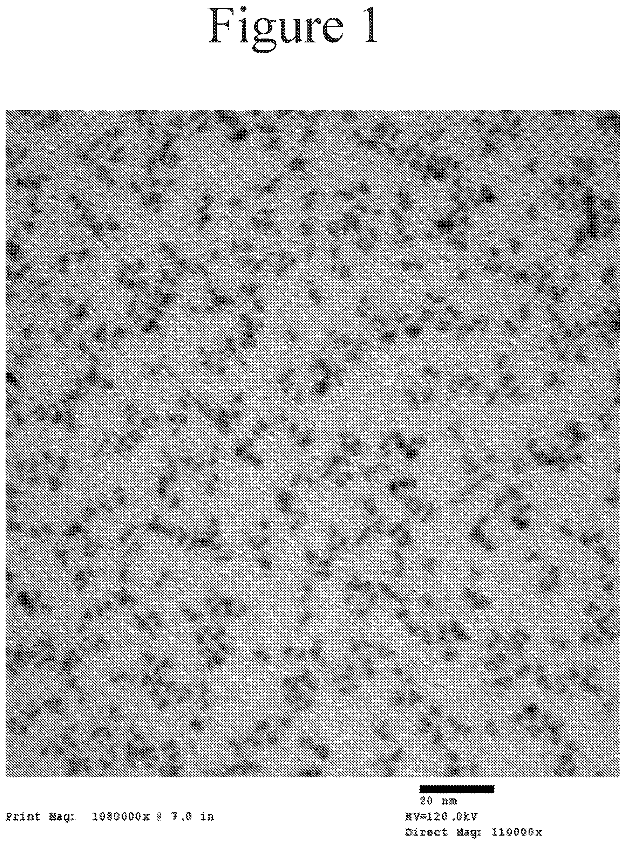

FIGURE 1 is a transmission electron micrograph (TEM) of a thin shell InP quantum dot with a target shell thickness of 1.3 monolayers of ZnSe and 4.5 monolayers of ZnS prepared using low temperature synthesis. The thin shell InP/ZnSe/ZnS quantum dot has a mean particle diameter of 3.2 ± 0.4 nm.

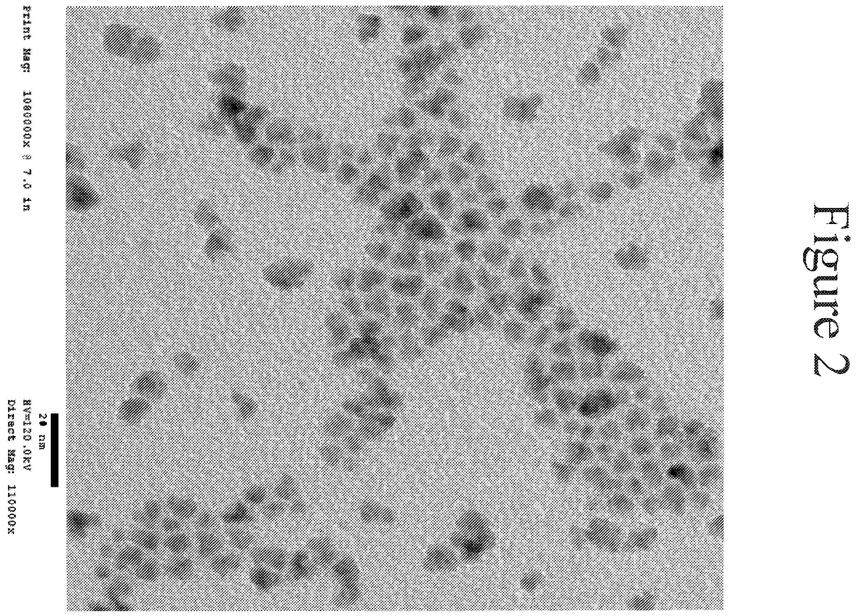

FIGURE 2 is a TEM image of a thick shell InP quantum dot with a target shell thickness of 3.5 monolayers of ZnSe and 4.5 monolayers of ZnS prepared using the high temperature method of the present invention. The thick shell InP/ZnSe/ZnS quantum dot has a mean particle diameter of 5.85 ± 0.99 nm (6.93 nm calculated) with a particle diameter range from 3.5 nm to 7.8 nm.

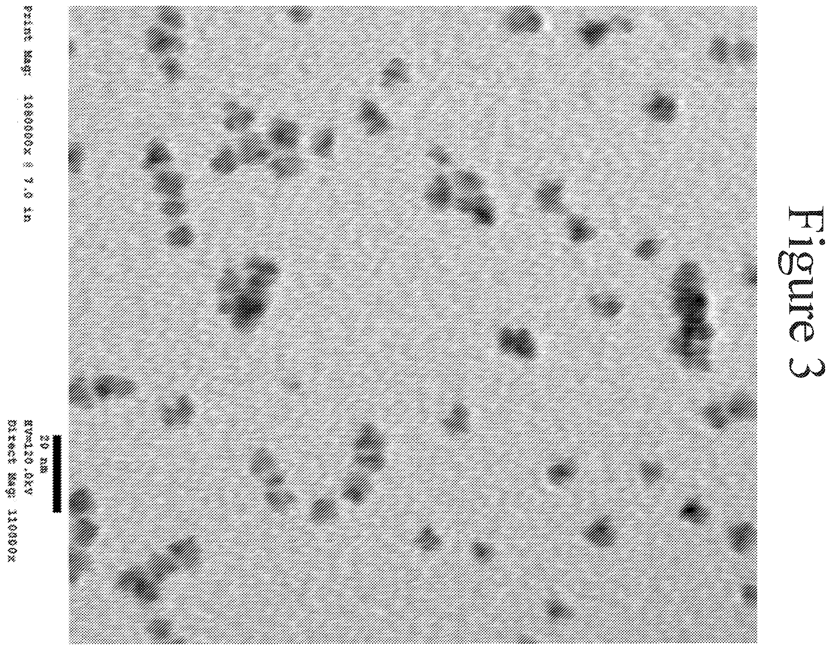

FIGURE 3 is a TEM image of a thick shell InP quantum dot with a target shell thickness of 1.5 monolayers of ZnSe and 7.5 monolayers of ZnS prepared using the high temperature method of the present invention. The thick shell InP/ZnSe/ZnS quantum dot has a mean particle diameter of 6.3 ± 0.8 nm (7.5 nm calculated).

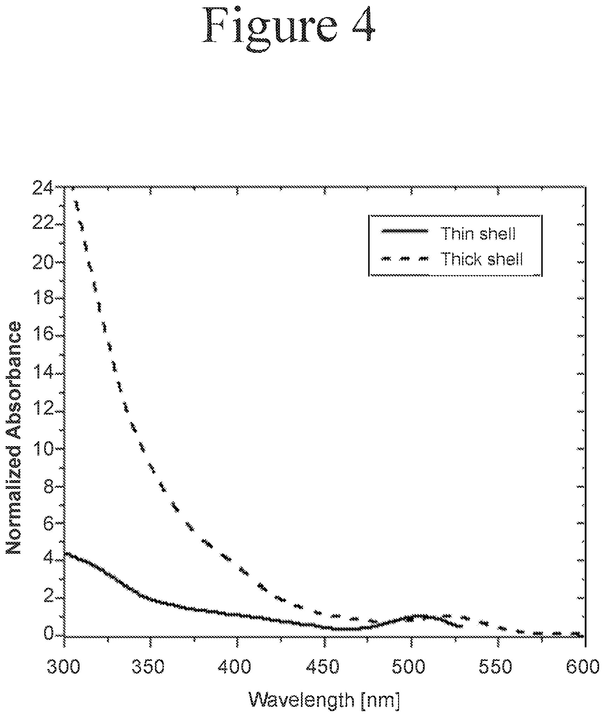

FIGURE 4 are absorbance spectra of a thin shell InP quantum dot with 1.3 layers of ZnSe and 4.5 monolayers of ZnS prepared using a low temperature synthesis and a thick shell InP quantum dot with 3.5 monolayers of ZnSe and 4.5 monolayers of ZnS prepared using the high temperature method of the present invention. There is a substantial increase in absorption in the low wavelength region for the thick shell compared to the thin shell InP/ZnSe/ZnS quantum dot.

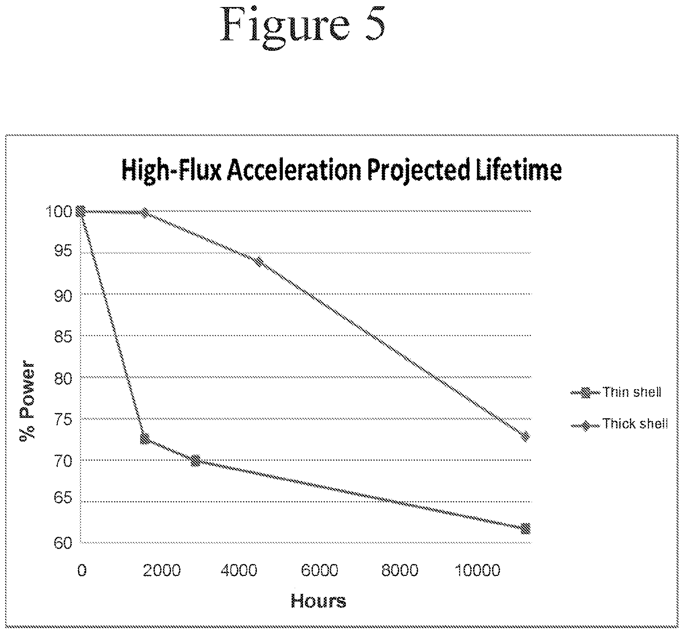

FIGURE 5 is a graph showing the results of an accelerated lifetime test under high flux blue light exposure over time for a thin shell InP quantum dot with 1.3 monolayers of ZnSe and 4.5 monolayers of ZnS prepared using a low temperature synthesis and a thick shell InP quantum dot with 3.5 monolayers of ZnSe and 4.5 monolayers of ZnS prepared using the high temperature method of the present invention. As shown in the graph, thin shell InP quantum dots show a steep drop within a few hundred hours of projected lifetime and then continue to decline. Conversely, thick shell quantum dots maintain their initial brightness for several thousand hours and have a delayed onset of degradation.

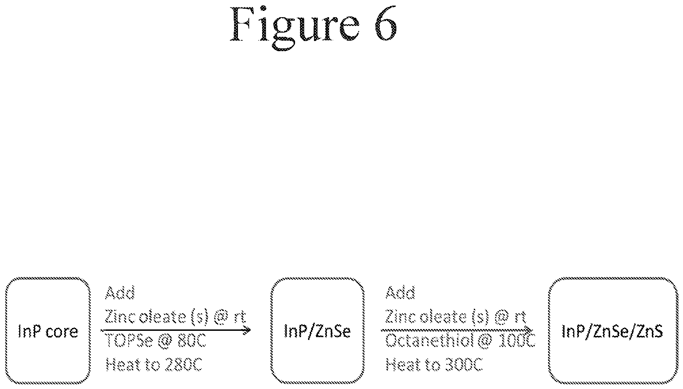

FIGURE 6 is a schematic showing a method of synthesizing InP/ZnSe/ZnS nanoparticles using the high temperature method of the present invention where trioctylphosphine selenide (TOPSe) is used as the selenium source.

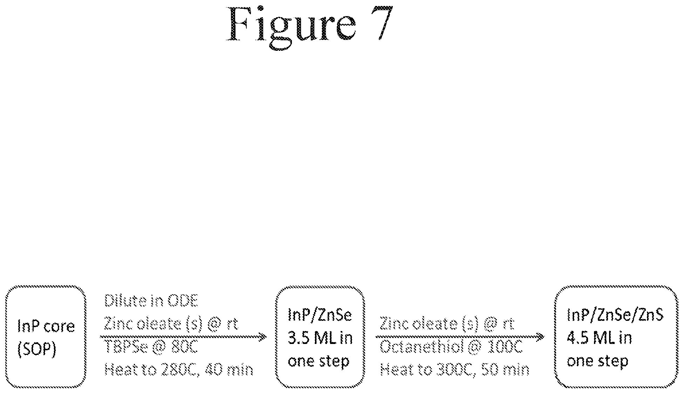

FIGURE 7 is a schematic showing a method of synthesizing InP/ZnSe/ZnS nanoparticles using the high temperature method of the present invention where tri-n-butylphosphine selenide (TBPSe) is used as the selenium source.

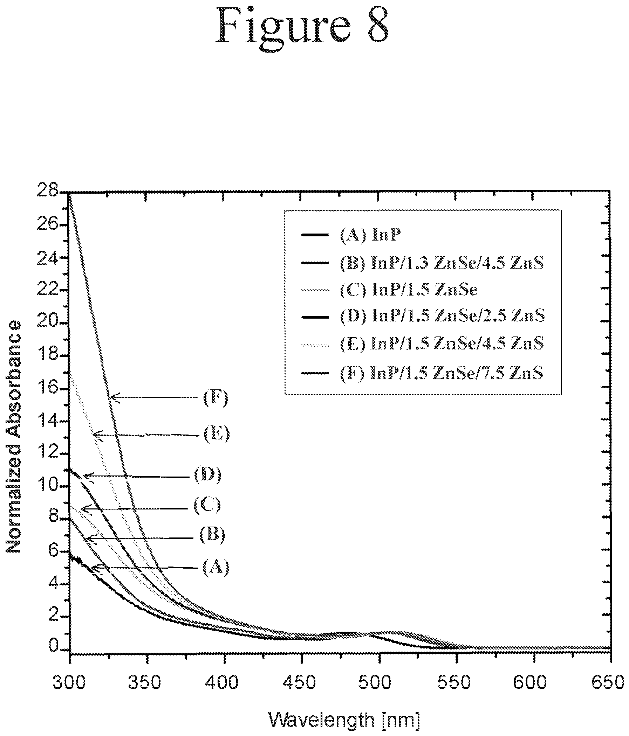

FIGURE 8 are absorption spectra for the following quantum dots at a wavelength of 300 nm to 650 nm: (A) an InP core quantum dot; (B) an InP core with 1.3 monolayers of ZnSe and 4.5 monolayers of ZnS prepared using a low temperature method; (C) an InP core with 1.5 monolayers of ZnSe prepared using TOPSe as the selenium source and the high temperature method of present invention; (D) an InP core with 1.5 monolayers of ZnSe and 2.5 monolayers of ZnS prepared using TOPSe as the selenium source and the high temperature method of the present invention; (E) an InP core with 1.5 layers of ZnSe and 4.5 monolayers of ZnS prepared using TOPSe as the selenium source and the high temperature method of the present invention; (F) an InP core with 1.5 monolayers of ZnSe and 7.5 monolayers of ZnS prepared using TOPSe as the selenium source and the high temperature method of the present invention. As shown in the spectra, there is an increase in absorbance below a wavelength of 360 nm for InP core quantum dots having thick shells prepared using the high temperature method of the present invention compared to the thin shells prepared with the low temperature method.

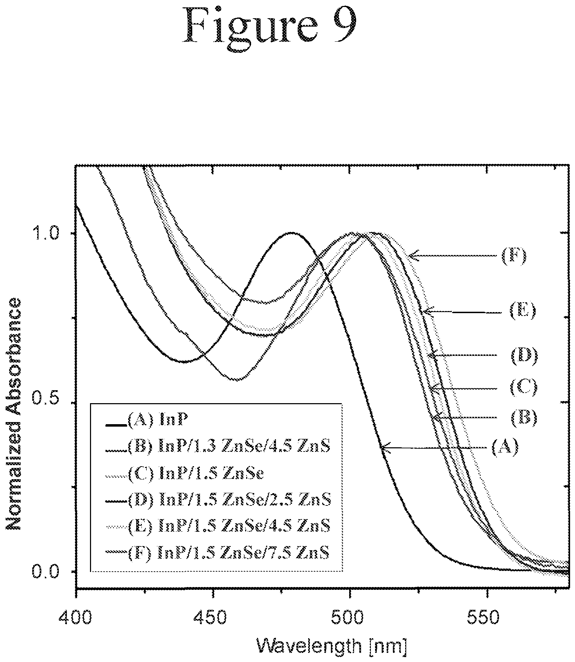

FIGURE 9 are absorption spectra for the following quantum dots at a wavelength of 400 nm to 575 nm: (A) an InP core quantum dot; (B) an InP core with 1.3 layers of ZnSe and 4.5 layers of ZnS prepared using a low temperature method; (C) an InP core with 1.5 layers of ZnSe prepared using TOPSe as the selenium source and the high temperature method of present invention; (D) an InP core with 1.5 layers of ZnSe and 2.5 layers of ZnS prepared using TOPSe as the selenium source and the high temperature method of the present invention; (E) an InP core with 1.5 layers of ZnSe and 4.5 layers of ZnS prepared using TOPSe as the selenium source and the high temperature method of the present invention; (F) an InP core with 1.5 layers of ZnSe and 7.5 layers of ZnS prepared using TOPSe as the selenium source and the high temperature method of the present invention. As shown in the spectra, there is a red shift with increasing layers of ZnSe and a blue shift with increasing layers of ZnS.

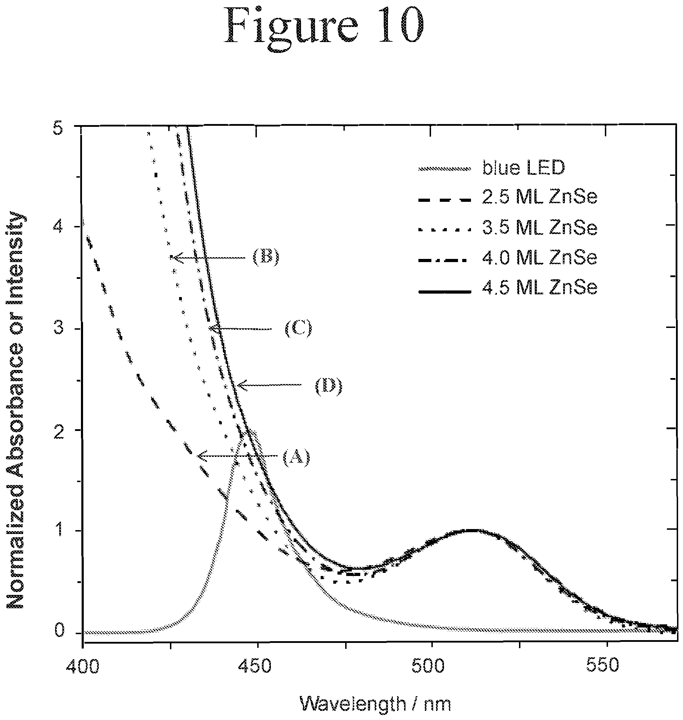

FIGURE 10 are absorption spectra of quantum dots comprising green InP cores at a wavelength of 400 nm to 575 nm with (A) 2.5 monolayers of ZnSe and 2.0 monolayers of ZnS; (B) 3.5 monolayers of ZnSe and 2.5 monolayers of ZnS; (C) 4.0 monolayers of ZnSe and 2.5 monolayers of ZnS; and (D) 4.5 monolayers of ZnSe and 2.0 monolayers of ZnS. A blue LED spectrum is shown for comparison.

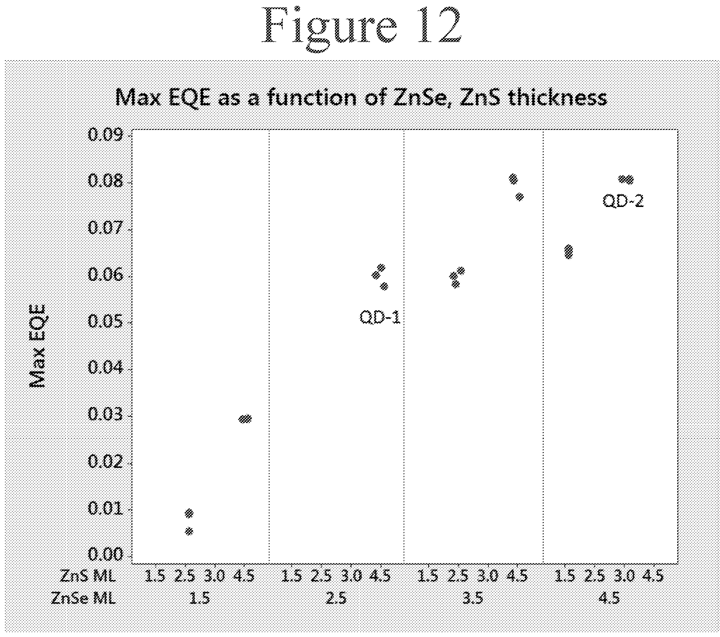

FIGURE 12 is a graph showing maximum external quantum efficiency (EQE) as a function of the number of monolayers of ZnS and ZnSe shells on InP quantum dots used in quantum dot light emitting devices. QD-1 are quantum dot light emitting devices prepared using InP quantum dot shells comprising 2.5 monolayers of ZnSe shell and 4.5 monolayers of ZnS shell. QD-2 are quantum dot light emitting devices prepared using InP quantum dots comprising 4.5 monolayers of ZnSe shell and 3 monolayers of ZnS shell.

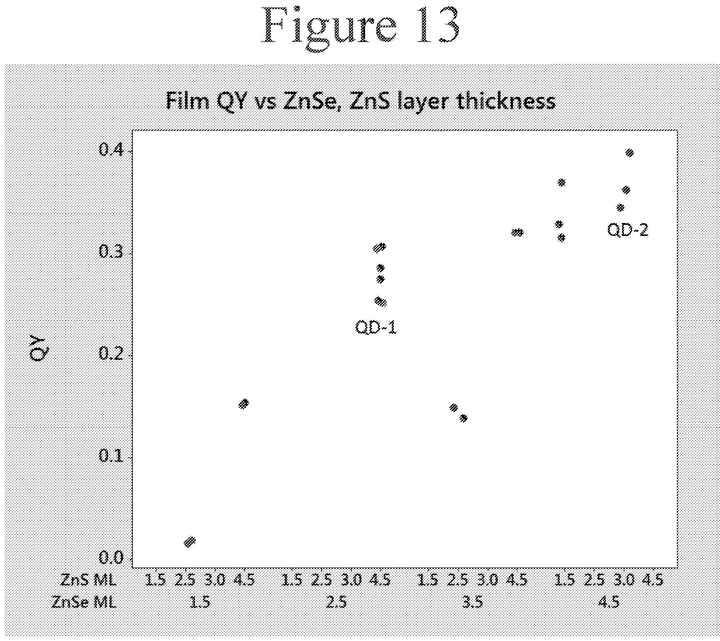

FIGURE 13 is a graph showing the film quantum yield as a function of the number of monolayers of ZnS and ZnSe shells on InP quantum dots used in the quantum dot light emitting devices. QD-1 are quantum dot light emitting devices prepared using InP quantum dot shells comprising 2.5 monolayers of ZnSe shell and 4.5 monolayers of ZnS shell. QD-2 are quantum dot light emitting devices prepared using InP quantum dots comprising 4.5 monolayers of ZnSe shell and 3 monolayers of ZnS shell.

DETAILED DESCRIPTION OF THE INVENTION

Definitions

Unless defined otherwise, all technical and scientific terms used herein have the same meaning as commonly understood by one of ordinary skill in the art to which the invention pertains. The following definitions supplement those in the art and are directed to the current application and are not to be imputed to any related or unrelated case, e.g., to any commonly owned patent or application. Although any methods and materials similar or equivalent to those described herein can be used in the practice for testing of the present invention, the preferred materials and methods are described herein. Accordingly, the terminology used herein is for the purpose of describing particular embodiments only, and is not intended to be limiting.

As used in this specification and the appended claims, the singular forms "a," "an" and "the" include plural referents unless the context clearly dictates otherwise. Thus, for example, reference to "a nanostructure" includes a plurality of such nanostructures, and the like.

The term "about" as used herein indicates the value of a given quantity varies by $\pm$ 10% of the value, or optionally $\pm$ 5% of the value, or in some embodiments, by $\pm$ 1% of the value so described. For example, "about 100 nm" encompasses a range of sizes from 90 nm to 110 nm, inclusive.

A "nanostructure" is a structure having at least one region or characteristic dimension with a dimension of less than about 500 nm. In some embodiments, the nanostructure has a dimension of less than about 200 nm, less than about 100 nm, less than about 50 nm, less than about 20 nm, or less than about 10 nm. Typically, the region or characteristic dimension will be along the smallest axis of the structure. Examples of such structures include nanowires, nanorods, nanotubes, branched nanostructures, nanotetrapods, tripods, bipods, nanocrystals, nanodots, quantum dots, nanoparticles, and the like. Nanostructures can be, e.g., substantially crystalline, substantially monocrystalline, polycrystalline, amorphous, or a combination thereof. In some embodiments, each of the three dimensions of the nanostructure has a dimension of less than about 500 nm, less than about 200 nm, less than about 100 nm, less than about 50 nm, less than about 20 nm, or less than about 10 nm.

The term "heterostructure" when used with reference to nanostructures refers to nanostructures characterized by at least two different and/or distinguishable material types. Typically, one region of the nanostructure comprises a first material type, while a second region of the nanostructure comprises a second material type. In certain embodiments, the nanostructure comprises a core of a first material and at least one shell of a second (or third etc.) material, where the different material types are distributed radially about the long axis of a nanowire, a long axis of an arm of a branched nanowire, or the center of a nanocrystal, for example. A shell can but need not completely cover the adjacent materials to be considered a shell or for the nanostructure to be considered a heterostructure; for example, a nanocrystal characterized by a core of one material covered with small islands of a second material is a heterostructure. In other embodiments, the different material types are distributed at different locations within the nanostructure; e.g., along the major (long) axis of a nanowire or along a long axis of arm of a branched nanowire. Different regions within a heterostructure can comprise entirely different materials, or the different regions can comprise a base material (e.g., silicon) having different dopants or different concentrations of the same dopant.

As used herein, the "diameter" of a nanostructure refers to the diameter of a cross-section normal to a first axis of the nanostructure, where the first axis has the greatest difference in length with respect to the second and third axes (the second and third axes are the two axes whose lengths most nearly equal each other). The first axis is not necessarily the longest axis of the nanostructure; e.g., for a disk-shaped nanostructure, the cross-section would be a substantially circular cross-section normal to the short longitudinal axis of the disk. Where the cross-section is not circular, the diameter is the average of the major and minor axes of that cross-section. For an elongated or high aspect ratio nanostructure, such as a nanowire, the diameter is measured across a cross- section perpendicular to the longest axis of the nanowire. For a spherical nanostructure, the diameter is measured from one side to the other through the center of the sphere.

The terms "crystalline" or "substantially crystalline," when used with respect to nanostructures, refer to the fact that the nanostructures typically exhibit long-range ordering across one or more dimensions of the structure. It will be understood by one of skill in the art that the term "long range ordering" will depend on the absolute size of the specific nanostructures, as ordering for a single crystal cannot extend beyond the boundaries of the crystal. In this case, "long-range ordering" will mean substantial order across at least the majority of the dimension of the nanostructure. In some instances, a nanostructure can bear an oxide or other coating, or can be comprised of a core and at least one shell. In such instances it will be appreciated that the oxide, shell(s), or other coating can but need not exhibit such ordering (e.g. it can be amorphous, polycrystalline, or otherwise). In such instances, the phrase "crystalline," "substantially crystalline," "substantially monocrystalline," or "monocrystalline" refers to the central core of the nanostructure (excluding the coating layers or shells). The terms "crystalline" or "substantially crystalline" as used herein are intended to also encompass structures comprising various defects, stacking faults, atomic substitutions, and the like, as long as the structure exhibits substantial long range ordering (e.g., order over at least about 80% of the length of at least one axis of the nanostructure or its core). In addition, it will be appreciated that the interface between a core and the outside of a nanostructure or between a core and an adjacent shell or between a shell and a second adjacent shell may contain non-crystalline regions and may even be amorphous. This does not prevent the nanostructure from being crystalline or substantially crystalline as defined herein.

The term "monocrystalline" when used with respect to a nanostructure indicates that the nanostructure is substantially crystalline and comprises substantially a single crystal. When used with respect to a nanostructure heterostructure comprising a core and one or more shells, "monocrystalline" indicates that the core is substantially crystalline and comprises substantially a single crystal.

A "nanocrystal" is a nanostructure that is substantially monocrystalline. A nanocrystal thus has at least one region or characteristic dimension with a dimension of less than about 500 nm. In some embodiments, the nanocrystal has a dimension of less than about 200 nm, less than about 100 nm, less than about 50 nm, less than about 20 nm, or less than about 10 nm. The term "nanocrystal" is intended to encompass substantially monocrystalline nanostructures comprising various defects, stacking faults, atomic substitutions, and the like, as well as substantially monocrystalline nanostructures without such defects, faults, or substitutions. In the case of nanocrystal heterostructures comprising a core and one or more shells, the core of the nanocrystal is typically substantially monocrystalline, but the shell(s) need not be. In some embodiments, each of the three dimensions of the nanocrystal has a dimension of less than about 500 nm, less than about 200 nm, less than about 100 nm, less than about 50 nm, less than about 20 nm, or less than about 10 nm.

The term "quantum dot" (or "dot") refers to a nanocrystal that exhibits quantum confinement or exciton confinement. Quantum dots can be substantially homogenous in material properties, or in certain embodiments, can be heterogeneous, e.g., including a core and at least one shell. The optical properties of quantum dots can be influenced by their particle size, chemical composition, and/or surface composition, and can be determined by suitable optical testing available in the art. The ability to tailor the nanocrystal size, e.g., in the range between about 1 nm and about 15 nm, enables photoemission coverage in the entire optical spectrum to offer great versatility in color rendering. [0103] A "ligand" is a molecule capable of interacting (whether weakly or strongly) with one or more faces of a nanostructure, e.g., through covalent, ionic, van der Waals, or other molecular interactions with the surface of the nanostructure.

"Photoluminescence quantum yield" is the ratio of photons emitted to photons absorbed, e.g., by a nanostructure or population of nanostructures. As known in the art, quantum yield is typically determined by a comparative method using well-characterized standard samples with known quantum yield values.

As used herein, the term "monolayer" is a measurement unit of shell thickness derived from the bulk crystal structure of the shell material as the closest distance between relevant lattice planes. By way of example, for cubic lattice structures the thickness of one monolayer is determined as the distance between adjacent lattice planes in the [111] direction. By way of example, one monolayer of cubic ZnSe corresponds to 0.328 nm and one monolayer of cubic ZnS corresponds to 0.31 nm thickness. The thickness of a monolayer of alloyed materials can be determined from the alloy composition through Vegard's law.

As used herein, the term "shell" refers to material deposited onto the core or onto previously deposited shells of the same or different composition and that result from a single act of deposition of the shell material. The exact shell thickness depends on the material as well as the precursor input and conversion and can be reported in nanometers or monolayers. As used herein, "target shell thickness" refers to the intended shell thickness used for calculation of the required precursor amount. As used herein, "actual shell thickness" refers to the actually deposited amount of shell material after the synthesis and can be measured by methods known in the art. By way of example, actual shell thickness can be measured by comparing particle diameters determined from TEM images of nanocrystals before and after a shell synthesis.

As used herein, the term "full width at half-maximum" (FWHM) is a measure of the size distribution of quantum dots. The emission spectra of quantum dots generally have the shape of a Gaussian curve. The width of the Gaussian curve is defined as the FWHM and gives an idea of the size distribution of the particles. A smaller FWHM corresponds to a narrower quantum dot nanocrystal size distribution. FWHM is also dependent upon the emission wavelength maximum. [0108] As used herein, the term "external quantum efficiency" (EQE) is a ratio of the number of photons emitted from a light emitting diode (LED) to the number of electrons passing through the device. The EQE measures how efficiently a LED converts electrons to photons and allows them to escape. EQE can be measured using the formula:

$$EQE = [\text{injection efficiency}] \times [\text{internal quantum efficiency}] \times [\text{extraction efficiency}]$$

where:

injection efficiency = the proportion of electrons passing through the device that are injected into the active region; internal quantum efficiency = the proportion of all electron-hole recombinations in the active region that are radiative and thus, produce electrons; and
extraction efficiency = the proportion of photons generated in the active region that escape from the device.

"Alkyl" as used herein refers to a straight or branched, saturated, aliphatic radical having the number of carbon atoms indicated. In some embodiments, the alkyl is C1-2 alkyl, C1-3 alkyl, C1-4 alkyl, Ci-5 alkyl, Ci-6 alkyl, C1-7 alkyl, C1-8 alkyl, Ci-9 alkyl, Ci-io alkyl, C1-12 alkyl, C1-14 alkyl, Ci.i6 alkyl, C1-18 alkyl, Ci-20 alkyl, C8-20 alkyl, Ci2-20 alkyl, C14-20 alkyl, C16-20 alkyl, or Ci8-2 o alkyl. For example, Ci-6 alkyl includes, but is not limited to, methyl, ethyl, propyl, isopropyl, butyl, isobutyl, sec-butyl, tert-butyl, pentyl, isopentyl, and hexyl. In some embodiments, the alkyl is octyl, nonyl, decyl, undecyl, dodecyl, tridecyl, tetradecyl, pentadecyl, hexadecyl, heptadecyl, octadecyl, nonadecyl, or icosanyl.

Unless clearly indicated otherwise, ranges listed herein are inclusive.

A variety of additional terms are defined or otherwise characterized herein.

Production of a Core

Methods for colloidal synthesis of a variety of nanostructures are known in the art. Such methods include techniques for controlling nanostructure growth, e.g., to control the size and/or shape distribution of the resulting nanostructures.

In a typical colloidal synthesis, semiconductor nanostructures are produced by rapidly injecting precursors that undergo pyrolysis into a hot solution (e.g., hot solvent and/or surfactant). The precursors can be injected simultaneously or sequentially. The precursors rapidly react to form nuclei. Nanostructure growth occurs through monomer addition to the nuclei, typically at a growth temperature that is lower than the injection/nucleation temperature.

Ligands interact with the surface of the nanostructure. At the growth temperature, the ligands rapidly adsorb and desorb from the nanostructure surface, permitting the addition and/or removal of atoms from the nanostructure while suppressing aggregation of the growing nanostructures. In general, a ligand that coordinates weakly to the nanostructure surface permits rapid growth of the nanostructure, while a ligand that binds more strongly to the nanostructure surface results in slower nanostructure growth. The ligand can also interact with one (or more) of the precursors to slow nanostructure growth.

Nanostructure growth in the presence of a single ligand typically results in spherical nanostructures. Using a mixture of two or more ligands, however, permits growth to be controlled such that non-spherical nanostructures can be produced, if, for example, the two (or more) ligands adsorb differently to different crystallographic faces of the growing nanostructure.

A number of parameters are thus known to affect nanostructure growth and can be manipulated, independently or in combination, to control the size and/or shape distribution of the resulting nanostructures. These include, e.g., temperature (nucleation and/or growth), precursor composition, time-dependent precursor concentration, ratio of the precursors to each other, surfactant composition, number of surfactants, and ratio of surfactant(s) to each other and/or to the precursors.

The synthesis of Group II- VI nanostructures has been described in U.S. Patent Nos. 6,225,198, 6,322,901, 6,207,229, 6,607,829, 7,060,243, 7,374,824, 6,861, 155, 7, 125,605, 7,566,476, 8, 158,193, and 8,101,234 and in U.S. Patent Appl. Publication Nos. 2011/0262752 and 2011/0263062. In some embodiments, the core is a Group II- VI nanocrystal selected from the group consisting of ZnO, ZnSe, ZnS, ZnTe, CdO, CdSe, CdS, CdTe, HgO, HgSe, HgS, and HgTe. In some embodiments, the core is a nanocrystal selected from the group consisting of ZnSe, ZnS, CdSe, and CdS.

Although Group II- VI nanostructures such as CdSe and CdS quantum dots can exhibit desirable luminescence behavior, issues such as the toxicity of cadmium limit the applications for which such nanostructures can be used. Less toxic alternatives with favorable luminescence properties are thus highly desirable. Group III-V nanostructures in general and InP-based nanostructures in particular, offer the best known substitute for cadmium-based materials due to their compatible emission range.

In some embodiments, the nanostructures are free from cadmium. As used herein, the term "free of cadmium" is intended that the nanostructures contain less than 100 ppm by weight of cadmium. The Restriction of Hazardous Substances (RoHS) compliance definition requires that there must be no more than 0.01 % (100 ppm) by weight of cadmium in the raw homogeneous precursor materials. The cadmium level in the Cd-free nanostructures of the present invention is limited by the trace metal concentration in the precursor materials. The trace metal (including cadmium) concentration in the precursor materials for the Cd-free nanostructures, can be measured by inductively coupled plasma mass spectroscopy (ICP-MS) analysis, and are on the parts per billion (ppb) level. In some embodiments, nanostructures that are "free of cadmium" contain less than about 50 ppm, less than about 20 ppm, less than about 10 ppm, or less than about 1 ppm of cadmium.

In some embodiments, the core is a InP nanocrystal.

The synthesis of Group III-V nanostructures has been described in U.S. Patent Nos. 5,505,928, 6,306,736, 6,576,291, 6,788,453, 6,821,337, 7,138,098, 7,557,028, 8,062,967, 7,645,397, and 8,282,412 and in U.S. Patent Appl. Publication No. 2015/236195. Synthesis of Group III-V nanostructures has also been described in Wells, R.L., et al., "The use of tris(trimethylsilyl)arsine to prepare gallium arsenide and indium arsenide," Chem. Mater. 7:4-6 (1989) and in Guzelian, A. A., et al., "Colloidal chemical synthesis and characterization of InAs nanocrystal quantum dots," Appl. Phys. Lett. 69: 1432-1434 (1996).

Synthesis of InP -based nanostructures has been described, e.g., in Xie, R., et al., "Colloidal InP nanocrystals as efficient emitters covering blue to near-infrared," J. Am. Chem. Soc. 729: 15432-15433 (2007); Micic, O.I., et al., "Core-shell quantum dots of lattice-matched ZnCdSe2 shells on InP cores: Experiment and theory," J. Phys. Chem. B 104: 12149-12156 (2000); Liu, Z., et al., "Coreduction colloidal synthesis of III-V nanocrystals: The case of InP," Angew. Chem. Int. Ed. Engl. ¥7:3540-3542 (2008); Li, L. et al., "Economic synthesis of high quality InP nanocrystals using calcium phosphide as the phosphorus precursor," Chem. Mater. 20:2621-2623 (2008); D. Battaglia and X. Peng, "Formation of high quality InP and InAs nanocrystals in a noncoordinating solvent," Nemo Letters 2: 1027-1030 (2002); Kim, S., et al., "Highly luminescent InP/GaP/ZnS nanocrystals and their application to white light-emitting diodes," J. Am. Chem. Soc. 734:3804-3809 (2012); Nann, T., et al., "Water splitting by visible light: A nanophotocathode for hydrogen production," Angew. Chem. Int. Ed. ¥9: 1574-1577 (2010); Borchert, H., et al., "Investigation of ZnS passivated InP nanocrystals by XPS," Nano Letters 2: 151-154 (2002); L. Li and P. Reiss, "One-pot synthesis of highly luminescent InP/ZnS nanocrystals without precursor injection," J. Am. Chem. Soc. 730: 11588-11589 (2008); Hussain, S., et al. "One-pot fabrication of high-quality InP/ZnS (core/shell) quantum dots and their application to cellular imaging," Chemphyschem. JO A466-1410 (2009); Xu, S., et al., "Rapid synthesis of high-quality InP nanocrystals," J. Am. Chem. Soc. 725: 1054-1055 (2006); Micic, O.I., et al., "Size-dependent spectroscopy of InP quantum dots," J. Phys. Chem. B 707:4904-4912 (1997); Haubold, S., et al., "Strongly luminescent InP/ZnS core-shell nanoparticles," Chemphyschem. 5:331-334 (2001); CrosGagneux, A., et al., "Surface chemistry of InP quantum dots: A comprehensive study," J. Am. Chem. Soc. 732: 18147-18157 (2010); Micic, O.I., et al., "Synthesis and characterization of InP, GaP, and GaInP2 quantum dots," J. Phys. Chem. 99:7754-7759 (1995); Guzelian, A.A., et al., "Synthesis of size-selected, surface- passivated InP nanocrystals," J. Phys. Chem. 700:7212-7219 (1996); Lucey, D.W., et al., "Monodispersed InP quantum dots prepared by colloidal chemistry in a non-coordinating solvent," Chem. Mater. 77:3754-3762 (2005); Lim, 1, et al., "InP@ZnSeS, core@composition gradient shell quantum dots with enhanced stability," Chem. Mater. 23:4459-4463 (2011); and Zan, F., et al., "Experimental studies on blinking behavior of single InP/ZnS quantum dots: Effects of synthetic conditions and UV irradiation," J. Phys. Chem. C 77(5:394-3950 (2012). However, such efforts have had only limited success in producing InP nanostructures with high quantum yields.

In some embodiments, the core is doped. In some embodiments, the dopant of the nanocrystal core comprises a metal, including one or more transition metals. In some embodiments, the dopant is a transition metal selected from the group consisting of Ti, Zr, Hf, V, Nb, Ta, Cr, Mo, W, Mn, Tc, Re, Fe, Ru, Os, Co, Rh, Ir, Ni, Pd, Pt, Cu, Ag, Au, and combinations thereof. In some embodiments, the dopant comprises a non-metal. In some embodiments, the dopant is ZnS, ZnSe, ZnTe, CdSe, CdS, CdTe, HgS, HgSe, HgTe, $CuInS_2$, $CuInSe_2$, AIN, AIP, AlAs, GaN, GaP, or GaAs.

In some embodiments, the core is purified before deposition of a shell. In some embodiments, the core is filtered to remove precipitate from the core solution.

In some embodiments, the core is subjected to an acid etching step before deposition of a shell.

In some embodiments, the diameter of the core is determined using quantum confinement. Quantum confinement in zero-dimensional nanocrystallites, such as quantum dots, arises from the spatial confinement of electrons within the crystallite boundary. Quantum confinement can be observed once the diameter of the material is of the same magnitude as the de Broglie wavelength of the wave function. The electronic and optical properties of nanoparticles deviate substantially from those of bulk materials. A particle behaves as if it were free when the confining dimension is large compared to the wavelength of the particle. During this state, the band gap remains at its original energy due to a continuous energy state. However, as the confining dimension decreases and reaches a certain limit, typically in nanoscale, the energy spectrum becomes discrete. As a result, the band gap becomes size-dependent.

Production of a Shell

The nanostructures of the present invention include a core and at least two shells. The shell can, e.g., increase the quantum yield and/or stability of the nanostructures.

In some embodiments, the shell is deposited by a mixture of at least two of a zinc source, a selenium source, a sulfur source. The shell is composed of zinc and sulfur; zinc and selenium..

In some embodiments, a shell comprises more than one monolayer of shell material. The number of monolayers is an average for all the nanostructures; therefore, the number of monolayers in a shell may be a fraction. In some embodiments, the number of monolayers in a shell is between 0.25 and 10, between 0.25 and 8, between 0.25 and 7, between 0.25 and 6, between 0.25 and 5, between 0.25 and 4, between 0.25 and 3, between 0.25 and 2, between 2 and 10, between 2 and 8, between 2 and 7, between 2 and 6, between 2 and 5, between 2 and 4, between 2 and 3, between 3 and 10, between 3 and 8, between 3 and 7, between 3 and 6, between 3 and 5, between 3 and 4, between 4 and 10, between 4 and 8, between 4 and 7, between 4 and 6, between 4 and 5, between 5 and 10, between 5 and 8, between 5 and 7, between 5 and 6, between 6 and 10, between 6 and 8, between 6 and 7, between 7 and 10, between 7 and 8, or between 8 and 10. In some embodiments, the shell comprises between 3 and 5 monolayers.

In some embodiments, the number of monolayers in a shell is between 0.25 and 12. In some embodiments, the number of monolayers in a shell is between 0.25 and 12, 0.25 and 10, 0.25 and 8, 0.25 and 7, 0.25 and 6, 0.25 and 5, 0.25 and 4, 0.25 and 3, or between 0.25 and 2.

The thickness of the shell can be controlled by varying the amount of precursor provided. For a given shell thickness, at least one of the precursors is optionally provided in an amount whereby, when a growth reaction is substantially complete, a shell of a predetermined thickness is obtained. If more than one different precursor is provided, either the amount of each precursor can be limited or one of the precursors can be provided in a limiting amount while the others are provided in excess.

The thickness of each shell can be determined using techniques known to those of skill in the art. In some embodiments, the thickness of each shell is determined by comparing the average diameter of the nanostructure before and after the addition of each shell. In some embodiments, the average diameter of the nanostructure before and after the addition of each shell is determined by TEM. In some embodiments, each shell has a thickness of between 0.7 nm and 3.5 nm, between 0.7 nm and 2 nm, between 0.7 nm and 0.9 nm, between 0.9 nm and 3.5 nm, between 0.9 nm and 2 nm, or between 2 nm and 3.5 nm.

In some embodiments, each shell is synthesized in the presence of at least one nanostructure ligand. Ligands can, e.g., enhance the miscibility of nanostructures in solvents or polymers (allowing the nanostructures to be distributed throughout a composition such that the nanostructures do not aggregate together), increase quantum yield of nanostructures, and/or preserve nanostructure luminescence (e.g., when the nanostructures are incorporated into a matrix). In some embodiments, the ligand(s) for the core synthesis and for the shell synthesis are the same. In some embodiments, the ligand(s) for the core synthesis and for the shell synthesis are different. Following synthesis, any ligand on the surface of the nanostructures can be exchanged for a different ligand with other desirable properties. Examples of ligands are disclosed in U.S. Patent Nos. 7,572,395, 8,143,703, 8,425,803, 8,563, 133, 8,916,064, 9,005,480, 9,139,770, and 9, 169,435, and in U.S. Patent Application Publication No. 2008/0118755.

Ligands suitable for the synthesis of a shell are known by those of skill in the art. In some embodiments, the ligand is a fatty acid selected from the group consisting of lauric acid, caproic acid, myristic acid, palmitic acid, stearic acid, and oleic acid. In some embodiments, the ligand is an organic phosphine or an organic phosphine oxide selected from trioctylphosphine oxide (TOPO), trioctylphosphine (TOP), diphenylphosphine (DPP), triphenylphosphine oxide, and tributylphosphine oxide. In some embodiments, the ligand is an amine selected from the group consisting of dodecylamine, oleylamine, hexadecylamine, dioctylamine, and octadecylamine. In some embodiments, the ligand is tributylphosphine, oleic acid, or zinc oleate.

In some embodiments, each shell is produced in the presence of a mixture of ligands. In some embodiments, each shell is produced in the presence of a mixture comprising 2, 3, 4, 5, or 6 different ligands. In some embodiments, each shell is produced in the presence of a mixture comprising 3 different ligands. In some embodiments, the mixture of ligands comprises tributylphosphine, oleic acid, and zinc oleate.

In some embodiments, each shell is produced in the presence of a solvent. In some embodiments, the solvent is selected from the group consisting of 1-octadecene, 1-hexadecene, 1-eicosene, eicosane, octadecane, hexadecane, tetradecane, squalene, squalane, trioctylphosphine oxide, and dioctyl ether. In some embodiments, the solvent is 1-octadecene.

In some embodiments, a core or a core/shell(s) and shell precursor are contacted at an addition temperature between 20 °C and 310 °C, between 20 °C and 280 °C, between 20 °C and 250 °C, between 20 °C and 200 °C, between 20 °C and 150 °C, between 20 °C and 100 °C, between 20 °C and 50 °C, between 50 °C and 310 °C, between 50 °C and 280 °C, between 50 °C and 250 °C, between 50 °C and 200 °C, between 50 °C and 150 °C, between 50 °C and 100 °C, between 100 °C and 310 °C, between 100 °C and 280 °C, between 100 °C and 250 °C, between 100 °C and 200 °C, between 100 °C and 150 °C, between 150 °C and 310 °C, between 150 °C and 280 °C, between 150 °C and 250 °C, between 150 °C and 200 °C, between 200 °C and 310 °C, between 200 °C and 280 °C, between 200 °C and 250 °C, between 250 °C and 310 °C, between 250 °C and 280 °C, or between 280 °C and 310 °C. In some embodiments, a core or a core/shell(s) and shell precursor are contacted at an addition temperature between 20 °C and 100 °C.

In some embodiments, after contacting a core or core/shell(s) and shell precursor, the temperature of the reaction mixture is increased to an elevated temperature between 200 °C and 310 °C, between 200 °C and 280 °C, between 200 °C and 250 °C, between 200 °C and 220 °C, between 220 °C and 310 °C, between 220 °C and 280 °C, between 220 °C and 250 °C, between 250 °C and 310 °C, between 250 °C and 280 °C, or between 280 °C and 310 °C. In some embodiments, after contacting a core or core/shell(s) and shell precursor, the temperature of the reaction mixture is increased to between 250 °C and 310 °C.

In some embodiments, after contacting a core or core/shell(s) and shell precursor, the time for the temperature to reach the elevated temperature is between 2 and 240 minutes, between 2 and 200 minutes, between 2 and 100 minutes, between 2 and 60 minutes, between 2 and 40 minutes, between 5 and 240 minutes, between 5 and 200 minutes, between 5 and 100 minutes, between 5 and 60 minutes, between 5 and 40 minutes, between 10 and 240 minutes, between 10 and 200 minutes, between 10 and 100 minutes, between 10 and 60 minutes, between 10 and 40 minutes, between 40 and 240 minutes, between 40 and 200 minutes, between 40 and 100 minutes, between 40 and 60 minutes, between 60 and 240 minutes, between 60 and 200 minutes, between 60 and 100 minutes, between 100 and 240 minutes, between 100 and 200 minutes, or between 200 and 240 minutes.

In some embodiments, after contacting a core or core/shell(s) and shell precursor, the temperature of the reaction mixture is maintained at an elevated temperature for between 2 and 240 minutes, between 2 and 200 minutes, between 2 and 100 minutes, between 2 and 60 minutes, between 2 and 40 minutes, between 5 and 240 minutes, between 5 and 200 minutes, between 5 and 100 minutes, between 5 and 60 minutes, between 5 and 40 minutes, between 10 and 240 minutes, between 10 and 200 minutes, between 10 and 100 minutes, between 10 and 60 minutes, between 10 and 40 minutes, between 40 and 240 minutes, between 40 and 200 minutes, between 40 and 100 minutes, between 40 and 60 minutes, between 60 and 240 minutes, between 60 and 200 minutes, between 60 and 100 minutes, between 100 and 240 minutes, between 100 and 200 minutes, or between 200 and 240 minutes. In some embodiments, after contacting a core or core/shell(s) and shell precursor, the temperature of the reaction mixture is maintained at an elevated temperature for between 30 and 120 minutes.

In some embodiments, additional shells are produced by further additions of shell material precursors that are added to the reaction mixture followed by maintaining at an elevated temperature. Typically, additional shell precursor is provided after reaction of the previous shell is substantially complete (e.g., when at least one of the previous precursors is depleted or removed from the reaction or when no additional growth is detectable). The further additions of precursor create additional shells.

In some embodiments, the nanostructure is cooled before the addition of additional shell material precursor to provide further shells. In some embodiments, the nanostructure is maintained at an elevated temperature before the addition of shell material precursor to provide further shells.

After sufficient layers of shell have been added for the nanostructure to reach the desired thickness and diameter, the nanostructure can be cooled. In some embodiments, the core/shell(s) nanostructures are cooled to room temperature. In some embodiments, an organic solvent is added to dilute the reaction mixture comprising the core/shell(s) nanostructures.

In some embodiments, the organic solvent used to dilute the reaction mixture is ethanol, hexane, pentane, toluene, benzene, diethylether, acetone, ethyl acetate, dichloromethane (methylene chloride), chloroform, dimethylformamide, or N-methylpyrrolidinone. In some embodiments, the organic solvent is toluene.

In some embodiments, core/shell(s) nanostructures are isolated. In some embodiments, the core/shell(s) nanostructures are isolated by precipitation using an organic solvent. In some embodiments, the core/shell(s) nanostructures are isolated by flocculation with ethanol.

The number of monolayers will determine the size of the core/shell(s) nanostructures. The size of the core/shell(s) nanostructures can be determined using techniques known to those of skill in the art. In some embodiments, the size of the core/shell(s) nanostructures is determined using TEM. In some embodiments, the core/shell(s) nanostructures have an average diameter of between 1 nm and 15 nm, between 1 nm and 10 nm, between 1 nm and 9 nm, between 1 nm and 8 nm, between 1 nm and 7 nm, between 1 nm and 6 nm, between 1 nm and 5 nm, between 5 nm and 15 nm, between 5 nm and 10 nm, between 5 nm and 9 nm, between 5 nm and 8 nm, between 5 nm and 7 nm, between 5 nm and 6 nm, between 6 nm and 15 nm, between 6 nm and 10 nm, between 6 nm and 9 nm, between 6 nm and 8 nm, between 6 nm and 7 nm, between 7 nm and 15 nm, between 7 nm and 10 nm, between 7 nm and 9 nm, between 7 nm and 8 nm, between 8 nm and 15 nm, between 8 nm and 10 nm, between 8 nm and 9 nm, between 9 nm and 15 nm, between 9 nm and 10 nm, or between 10 nm and 15 nm. In some embodiments, the core/shell(s) nanostructures have an average diameter of between 6 nm and 7 nm.

In some embodiments, the core/shell(s) nanostructure is subjected to an acid etching step before deposition of an additional shell.

Production of a ZnSe Shell

In some embodiments, the shell precursors contacted with a core or core/shell(s) nanostructure to prepare a ZnSe shell comprise a zinc source and a selenium source.

In some embodiments, the zinc source is a dialkyl zinc compound. In some embodiments, the zinc source is a zinc carboxylate. In some embodiments, the zinc source is diethylzinc, dimethylzinc, zinc acetate, zinc acetylacetonate, zinc iodide, zinc bromide, zinc chloride, zinc fluoride, zinc carbonate, zinc cyanide, zinc nitrate, zinc oleate, zinc oxide, zinc peroxide, zinc perchlorate, zinc sulfate, zinc hexanoate, zinc octanoate, zinc laurate, zinc myristate, zinc palmitate, zinc stearate, zinc dithiocarbamate, or mixtures thereof. In some embodiments, the zinc source is zinc oleate, zinc hexanoate, zinc octanoate, zinc laurate, zinc myristate, zinc palmitate, zinc stearate, zinc dithiocarbamate, or mixtures thereof. In some embodiments, the zinc source is zinc oleate.

In some embodiments, the selenium source is an alkyl-substituted selenourea. In some embodiments, the selenium source is a phosphine selenide. In some embodiments, the selenium source is selected from trioctylphosphine selenide, tri(n-butyl)phosphine selenide, tri(sec-butyl)phosphine selenide, tri(tert-butyl)phosphine selenide, trimethylphosphine selenide, triphenylphosphine selenide, diphenylphosphine selenide, phenylphosphine selenide, tricyclohexylphosphine selenide, cyclohexylphosphine selenide, 1-octaneselenol, 1-dodecaneselenol, selenophenol, elemental selenium, hydrogen selenide, bis(trimethylsilyl) selenide, selenourea, and mixtures thereof. In some embodiments, the selenium source is tri(n-butyl)phosphine selenide, tri(sec-butyl)phosphine selenide, or tri(tert-butyl)phosphine selenide. In some embodiments, the selenium source is trioctylphosphine selenide.

In some embodiments, the molar ratio of core to zinc source to prepare a ZnSe shell is between 1 :2 and 1 : 1000, between 1 :2 and 1 : 100, between 1 :2 and 1 :50, between 1 :2 and 1 :25, between 1 :2 and 1 : 15, between 1 :2 and 1 : 10, between 1 :2 and 1 :5, between 1 :5 and 1 : 1000, between 1 :5 and 1 : 100, between 1 :5 and 1 :50, between 1 :5 and 1 :25, between 1:5 and 1:15, between 1:5 and 1:10, between 1:10 and 1:1000, between 1:10 and 1:100, between 1:10 and 1:50, between 1:10 and 1:25, between 1:10 and 1:15, between 1:15 and 1:1000, between 1:15 and 1:100, between 1:15 and 1:50, between 1:15 and 1:25, between 1:25 and 1:1000, between 1:25 and 1:100, between 1:25 and 1:50, or between 1:50 and 1:1000, between 1:50 and 1:100, between 1:100 and 1:1000.

In some embodiments, the molar ratio of core to selenium source to prepare a ZnSe shell is between 1:2 and 1:1000, between 1:2 and 1:100, between 1:2 and 1:50, between 1:2 and 1:25, between 1:2 and 1:15, between 1:2 and 1:10, between 1:2 and 1:5, between 1:5 and 1:1000, between 1:5 and 1:100, between 1:5 and 1:50, between 1:5 and 1:25, between 1:5 and 1:15, between 1:5 and 1:10, between 1:10 and 1:1000, between 1:10 and 1:100, between 1:10 and 1:50, between 1:10 and 1:25, between 1:10 and 1:15, between 1:15 and 1 : 1000, between 1:15 and 1 : 100, between 1:15 and 1:50, between 1:15 and 1:25, between 1:25 and 1:1000, between 1:25 and 1:100, between 1:25 and 1:50, or between 1:50 and 1:1000, between 1:50 and 1:100, between 1:100 and 1:1000.

In some embodiments, the number of monolayers in a ZnSe shell is between 0.25 and 10, between 0.25 and 8, between 0.25 and 7, between 0.25 and 6, between 0.25 and 5, between 0.25 and 4, between 0.25 and 3, between 0.25 and 2, between 2 and 10, between 2 and 8, between 2 and 7, between 2 and 6, between 2 and 5, between 2 and 4, between 2 and 3, between 3 and 10, between 3 and 8, between 3 and 7, between 3 and 6, between 3 and 5, between 3 and 4, between 4 and 10, between 4 and 8, between 4 and 7, between 4 and 6, between 4 and 5, between 5 and 10, between 5 and 8, between 5 and 7, between 5 and 6, between 6 and 10, between 6 and 8, between 6 and 7, between 7 and 10, between 7 and 8, or between 8 and 10. In some embodiments, the ZnSe shell comprises between 2 and 6 monolayers. In some embodiments, the ZnSe shell comprises between 3 and 4 monolayers.

In some embodiments, the number of monolayers in a ZnSe shell is between 0.25 and 12. In some embodiments, the number of monolayers in a ZnSe shell is between 0.25 and 12, 0.25 and 10, 0.25 and 8, 0.25 and 7, 0.25 and 6, 0.25 and 5, 0.25 and 4, 0.25 and 3, or between 0.25 and 2.

In some embodiments, a ZnSe monolayer has a thickness of about 0.328 nm.

In some embodiments, a ZnSe shell has a thickness of between 0.7 nm and 3.5 nm, between 0.7 nm and 2 nm, between 0.7 nm and 0.9 nm, between 0.9 nm and 3.5 nm, between 0.9 nm and 2 nm, or between 2 nm and 3.5 nm.

Production of a ZnS Shell

The shell precursors contacted with a core or core/shell(s) nanostructure to prepare a ZnS shell comprise a zinc source and a sulfur source.

In some embodiments, the ZnS shell passivates defects at the particle surface, which leads to an improvement in the quantum yield and to higher efficiencies when used in devices such as LEDs and lasers. Furthermore, spectral impurities which are caused by defect states may be eliminated by passivation, which increases the color saturation.

In some embodiments, the zinc source is a dialkyl zinc compound. In some embodiments, the zinc source is a zinc carboxylate. In some embodiments, the zinc source is diethylzinc, dimethylzinc, zinc acetate, zinc acetylacetonate, zinc iodide, zinc bromide, zinc chloride, zinc fluoride, zinc carbonate, zinc cyanide, zinc nitrate, zinc oleate, zinc oxide, zinc peroxide, zinc perchlorate, zinc sulfate, zinc hexanoate, zinc octanoate, zinc laurate, zinc myristate, zinc palmitate, zinc stearate, zinc dithiocarbamate, or mixtures thereof. In some embodiments, the zinc source is zinc oleate, zinc hexanoate, zinc octanoate, zinc laurate, zinc myristate, zinc palmitate, zinc stearate, zinc dithiocarbamate, or mixtures thereof. In some embodiments, the zinc source is zinc oleate.

In some embodiments, the zinc source is produced by reacting a zinc salt with a carboxylic acid. In some embodiments, the carboxylic acid is selected from acetic acid, propionic acid, butyric acid, valeric acid, caproic acid, heptanoic acid, caprylic acid, capric acid, undecanoic acid, lauric acid, myristic acid, palmitic acid, stearic acid, behenic acid, acrylic acid, methacrylic acid, but-2-enoic acid, but-3-enoic acid, pent-2-enoic acid, pent-4-enoic acid, hex-2-enoic acid, hex-3-enoic acid, hex-4-enoic acid, hex-5-enoic acid, hept-6-enoic acid, oct-2-enoic acid, dec-2-enoic acid, undec-10-enoic acid, dodec-5-enoic acid, oleic acid, gadoleic acid, erucic acid, linoleic acid, a-linolenic acid, calendic acid, eicosadienoic acid, eicosatrienoic acid, arachidonic acid, stearidonic acid, benzoic acid, para-toluic acid, ortho-toluic acid, meta-toluic acid, hydrocinnamic acid, naphthenic acid, cinnamic acid, para-toluenesulfonic acid, and mixtures thereof.

In some embodiments, the sulfur source is selected from elemental sulfur, octanethiol, dodecanethiol, octadecanethiol, tributylphosphine sulfide, cyclohexyl isothiocyanate, a-toluenethiol, ethylene trithiocarbonate, allyl mercaptan, bis(trimethylsilyl) sulfide, trioctylphosphine sulfide, and mixtures thereof. In some embodiments, the sulfur source is an alkyl-substituted zinc dithiocarbamate. In some embodiments, the sulfur source is octanethiol. In some embodiments, the sulfur source is dodecanethiol.

In some embodiments, the molar ratio of core to zinc source to prepare a ZnS shell is between 1:2 and 1:1000, between 1:2 and 1:100, between 1:2 and 1:50, between 1:2 and 1:25, between 1:2 and 1:15, between 1:2 and 1:10, between 1:2 and 1:5, between 1:5 and 1:1000, between 1:5 and 1:100, between 1:5 and 1:50, between 1:5 and 1:25, between 1:5 and 1:15, between 1:5 and 1:10, between 1:10 and 1:1000, between 1:10 and 1:100, between 1:10 and 1:50, between 1:10 and 1:25, between 1:10 and 1:15, between 1:15 and 1:1000, between 1:15 and 1:100, between 1:15 and 1:50, between 1:15 and 1:25, between 1:25 and 1:1000, between 1:25 and 1:100, between 1:25 and 1:50, or between 1:50 and 1:1000, between 1:50 and 1:100, between 1:100 and 1:1000.

In some embodiments, the molar ratio of core to sulfur source to prepare a ZnS shell is between 1:2 and 1:1000, between 1:2 and 1:100, between 1:2 and 1:50, between 1:2 and 1:25, between 1:2 and 1:15, between 1:2 and 1:10, between 1:2 and 1:5, between 1:5 and 1:1000, between 1:5 and 1:100, between 1:5 and 1:50, between 1:5 and 1:25, between 1:5 and 1:15, between 1:5 and 1:10, between 1:10 and 1:1000, between 1:10 and 1:100, between 1:10 and 1:50, between 1:10 and 1:25, between 1:10 and 1:15, between 1:15 and 1:1000, between 1:15 and 1:100, between 1:15 and 1:50, between 1:15 and 1:25, between 1:25 and 1:1000, between 1:25 and 1:100, between 1:25 and 1:50, or between 1:50 and 1:1000, between 1:50 and 1:100, between 1:100 and 1:1000.

In some embodiments, the number of monolayers in a ZnS shell is between 0.25 and 10, between 0.25 and 8, between 0.25 and 7, between 0.25 and 6, between 0.25 and 5, between 0.25 and 4, between 0.25 and 3, between 0.25 and 2, between 2 and 10, between 2 and 8, between 2 and 7, between 2 and 6, between 2 and 5, between 2 and 4, between 2 and 3, between 3 and 10, between 3 and 8, between 3 and 7, between 3 and 6, between 3 and 5, between 3 and 4, between 4 and 10, between 4 and 8, between 4 and 7, between 4 and 6, between 4 and 5, between 5 and 10, between 5 and 8, between 5 and 7, between 5 and 6, between 6 and 10, between 6 and 8, between 6 and 7, between 7 and 10, between 7 and 8, or between 8 and 10. In some embodiments, the ZnS shell comprises between 2 and 12 monolayers. In some embodiments, the ZnS shell comprises between 4 and 6 monolayers.

In some embodiments, the number of monolayers in a ZnS shell is between 0.25 and 12. In some embodiments, the number of monolayers in a ZnS shell is between 0.25 and 12, 0.25 and 10, 0.25 and 8, 0.25 and 7, 0.25 and 6, 0.25 and 5, 0.25 and 4, 0.25 and 3, or between 0.25 and 2.

In some embodiments, a ZnS monolayer has a thickness of about 0.31 nm.

In some embodiments, a ZnS shell has a thickness of between 0.7 nm and 3.5 nm, between 0.7 nm and 2 nm, between 0.7 nm and 0.9 nm, between 0.9 nm and 3.5 nm, between 0.9 nm and 2 nm, or between 2 nm and 3.5 nm.

Core/Shell(s) Nanostructures

The core/shell(s) nanostructure is a InP/ZnSe/ZnS nanostructure.

In some embodiments, the core/shell(s) nanostructures display a high photoluminescence quantum yield. In some embodiments, the core/shell(s) nanostructures display a photoluminescence quantum yield of between 60% and 99%, between 60% and 95%, between 60% and 90%, between 60% and 85%, between 60% and 80%, between 60% and 70%, between 70% and 99%, between 70% and 95%, between 70% and 90%, between 70% and 85%, between 70% and 80%, between 80% and 99%, between 80% and 95%, between 80% to 90%, between 80% and 85%, between 85% and 99%, between 85% and 95%, between 80% and 85%, between 85% and 99%, between 85% and 90%, between 90% and 99%, between 90% and 95%, or between 95% and 99%. In some embodiments, the core/shell(s) nanostructures display a photoluminescence quantum yield of between 85% and 96%.

The photoluminescence spectrum of the core/shell(s) nanostructures can cover essentially any desired portion of the spectrum. In some embodiments, the photoluminescence spectrum for the core/shell(s) nanostructures have a emission maximum between 300 nm and 750 nm, between 300 nm and 650 nm, between 300 nm and 550 nm, between 300 nm and 450 nm, between 450 nm and 750 nm, between 450 nm and 650 nm, between 450 nm and 550 nm, between 450 nm and 750 nm, between 450 nm and 650 nm, between 450 nm and 550 nm, between 550 nm and 750 nm, between 550 nm and 650 nm, or between 650 nm and 750 nm. In some embodiments, the photoluminescence spectrum for the core/shell(s) nanostructures has an emission maximum of between 500 nm and 550 nm. In some embodiments, the photoluminescence spectrum for the core/shell(s) nanostructures has an emission maximum of between 600 nm and 650 nm.

The size distribution of the core/shell(s) nanostructures can be relatively narrow. In some embodiments, the photoluminescence spectrum of the population or core/shell(s) nanostructures can have a full width at half maximum of between 10 nm and 60 nm, between 10 nm and 40 nm, between 10 nm and 30 nm, between 10 nm and 20 nm, between 20 nm and 60 nm, between 20 nm and 40 nm, between 20 nm and 30 nm, between 30 nm and 60 nm, between 30 nm and 40 nm, or between 40 nm and 60 nm. In some embodiments, the photoluminescence spectrum of the population or core/shell(s) nanostructures can have a full width at half maximum of between 35 nm and 45 nm.

In some embodiments, the core/shell(s) nanostructures of the present invention are able to maintain high levels of photoluminescence intensity for long periods of time under continuous blue light exposure. In some embodiments, the core/shell(s) nanostructrures are able to maintain 90% intensity (compared to the starting intensity level) of at least 2,000 hours, at least 4,000 hours, at least 6,000 hours, at least 8,000 hours, or at least 10,000 hours. In some embodiments, the core/shell(s) nanostructures are able to maintain 80% intensity (compared to the starting intensity level) of at least 2,000 hours, at least 4,000 hours, at least 6,000 hours, at least 8,000 hours, or at least 10,000 hours. In some embodiments, the core/shell(s) nanostructures are able to maintain 70% intensity (compared to the starting intensity level) of at least 2,000 hours, at least 4,000 hours, at least 6,000 hours, at least 8,000 hours, or at least 10,000 hours.

The resulting core/shell(s) nanostructures are optionally embedded in a matrix (e.g., an organic polymer, silicon-containing polymer, inorganic, glassy, and/or other matrix), used in production of a nanostructure phosphor, and/or incorporated into a device, e.g., an LED, backlight, downlight, or other display or lighting unit or an optical filter. Exemplary phosphors and lighting units can, e.g., generate a specific color light by incorporating a population of nanostructures with an emission maximum at or near the desired wavelength or a wide color gamut by incorporating two or more different populations of nanostructures having different emission maxima. A variety of suitable matrices are known in the art. See, e.g., U.S. Patent No. 7,068,898 and U.S. Patent Application Publication Nos. 2010/0276638, 2007/0034833, and 2012/0113672. Exemplary nanostructure phosphor films, LEDs, backlighting units, etc. are described, e.g., in U.S. Patent Application Publications Nos. 2010/0276638, 2012/0113672, 2008/0237540, 2010/0110728, and 2010/0155749 and U.S. Patent Nos. 7,374,807, 7,645,397, 6,501,091, and 6,803,719.

The relative molar ratios of InP, ZnSe, and ZnS are calculated based on a spherical InP core of a given diameter by measuring the volumes, masses, and thus molar amounts of the desired spherical shells. For example, a green InP core of 1.8 nm diameter coated with 3 monolayers of ZnSe and 4 monolayers of ZnS requires 9.2 molar equivalents of ZnSe and 42.8 molar equivalents of ZnS relative to the molar amount of InP bound in the cores. This shell structure results in a total particle diameter of 6.23 nm. FIGURE 2 shows a TEM image of a synthesized sample of a green InP core of 1.8 nm diameter coated with 3 monolayers of ZnSe and 4 monolayers of ZnS that provides a particle size with a measured mean particle diameter of 5.9 nm. Comparison to previously investigated thin shell materials, as shown in FIGURE 1, with a mean particle size of 3.5 nm using the same type of cores shows that the shell thickness is more than doubled using the methods of the present invention. Additionally, the absorption spectrum of the green InP core in FIGURE 4 shows a substantial absorbance increase in the low wavelength region - where the ZnSe and ZnSe shell materials are absorbing. And, a photoluminescence excitation spectrum of the core/shell nanostructure follows the same shape and indicates that this additional absorbance is due to the shell material rather than from a secondary particle population.

The resulting core/shell(s) nanostructures can be used for imaging or labeling, e.g., biological imaging or labeling. Thus, the resulting core/shell(s) nanostructures are optionally covalently or noncovalently bound to biomolecule(s), including, but not limited to, a peptide or protein (e.g., an antibody or antibody domain, avidin, streptavidin, neutravidin, or other binding or recognition molecule), a ligand (e.g., biotin), a polynucleotide (e.g., a short oligonucleotide or longer nucleic acid), a carbohydrate, or a lipid (e.g., a phospholipid or other micelle). One or more core/shell(s) nanostructures can be bound to each biomolecule, as desired for a given application. Such core/shell(s) nanostructure-labeled biomolecules find use, for example, in vitro, in vivo, and in cellulo, e.g., in exploration of binding or chemical reactions as well as in subcellular, cellular, and organismal labeling. [0189] Core/shell(s) nanostructures resulting from the methods are also a feature of the invention. Thus, one class of embodiments provides a population of core/shell(s) nanostructures. In some embodiments, the core/shell(s) nanostructures are quantum dots.

Coating the Nanostructures with an Oxide Material

Regardless of their composition, most quantum dots do not retain their originally high quantum yield after continuous exposure to excitation photons. Although the use of thick shells may prove effective in mitigating the effects of photoinduced quantum yield deterioration, the photodegradation of quantum dots may be further retarded by encasing them with an oxide. Coating quantum dots with an oxide causes their surface to become physically isolated from their environments.

Coating quantum dots with an oxide material has been shown to increase their photostability. In Jo, J.-H., et al., J. Alloys & Compounds 647:6-13 (2015), InP/ZnS red-emitting quantum dots were overcoated with an oxide phase of In2 03 which was found to substantially alleviate quantum dot photodegradation as shown by comparative photostability results.

In some embodiments, the nanostructures are coated with an oxide material for increased stability. In some embodiments, the oxide material is $In_2O_3$, $SiO_2$, $Al_2O_3$, or $TiO_2$.

Quantum Dots with Increased Blue Light Absorption

In photoluminescent applications of quantum dots, light emission is stimulated by excitation with a higher energy light source. Typically, this is a blue LED with an emission peak in the range of 440 nm to 460 nm. Some quantum dots exhibit relatively low absorbance in this range which hampers performance- especially in applications where almost quantitative conversion of blue photons to quantum dot-emitted photons are desired. An example of such an application is a color filter in a display, where blue light leakage decreases color gamut coverage.

Green InP quantum dots suffer from low blue light absorption, because this wavelength range coincides with the absorption valley. This valley results from quantum confinement. The quantum confinement effect is observed when the size of a material is of the same magnitude as the de Broglie wavelength of the electron wave function. When materials are this small, their electronic and optical properties deviate substantially from those of bulk materials. Quantum confinement leads to a collapse of the continuous energy bands of a bulk material into discrete, atomic like energy levels. The discrete energy states lead to a discrete absorption spectrum, which is in contrast to the continuous absorption spectrum of a bulk semiconductor. Koole, R., "Size Effects on Semiconductor Nanoparticles." Nanopar -tides. Ed. C. de Mello Donega. Heidelberg, Berlin: Springer-Verlag, 2014. Pages 13-50.

Typically shells on quantum dot cores are used for passivation and stabilization and are not thought of as an optically active component. However, the shell on InP quantum dot cores can also take part in the photon conversion process. For example, metal doping has been shown to enhance light absorption in $CdSe/Cd_xPb_{1-x}S$ core/shell quantum dots, with the increased absorption attributed to Pb doping. Zhao, H., et al., Small 72:5354-5365 (2016).

CdSe/CdS core/shell quantum dots have been found to show reduced reabsorption up to a factor of 45 for quantum dots with thick shells (approximately 14 monolayers of CdS) as compared to initial CdSe cores. I. Coropceanu and M.G. Bawendi, Nano Lett. 14:4097-4101 (2014).

Photoluminescence excitation spectra measured at the core emission were found to follow a similar shape as the absorption spectra, which led to a realization that photons can be absorbed at high energy by the shell and the generated excitons can then be transferred with little or no loss to the core with resulting emission. Considering the ZnSe bulk band gap of 2.7 eV (460 nm), the ZnSe buffer layer may contribute to absorption in the desired range of 440-460 nm. To exploit this insight, quantum dots with thicker ZnSe buffers were synthesized and found to have even stronger absorbance in the wavelength range of 440-460 nm as shown in Figure 10.

In some embodiments, the absorption spectrum of the nanostructures can be measured using a UV-Vis spectrophotometer.

When a nanostructure absorbs light at a wavelength of between about 440 nm and about 495 nm, it absorbs blue light. In some embodiments, the blue light absorption of a nanostructure is measured at a wavelength between about 440 nm and about 495 nm, about 440 nm and about 480 nm, about 440 nm and about 460 nm, about 440 nm and about 450 nm, about 450 nm and about 495 nm, about 450 nm and about 480 nm, about 450 nm and about 460 nm, about 460 nm and about 495 nm, about 460 nm and about 480 nm, or about 480 nm and about 495 nm. In some embodiments, the blue light absorption of a nanostructure is measured at a wavelength of 440 nm, 450 nm, 460 nm, 480 nm, or 495 nm.

UV-Vis spectroscopy or UV-Vis spectrophotometry measures light in the visible and adjacent (near ultraviolet and near infrared) ranges. In this region of the electromagnetic spectrum, molecules undergo electronic transitions. UV-Vis spectroscopy is based on absorbance. In spectroscopy, the absorbance A is defined as:

$$A_\lambda = \log_{10}(I_0/I)$$

where I is the intensity of light at a specified wavelength $\lambda$ that has passed through a sample (transmitted light intensity) and I0 is the intensity of the light before it enters the sample or incident light. The term absorption refers to the physical process of absorbing light, while absorbance refers to the mathematical quantity. Although absorbance does not have true units, it is often reported in "absorbance units" or AU.

Optical density (OD) is the absorbance per unit length, i.e., the absorbance divided by the thickness of the sample. Optical density at wavelength $\lambda$ is defined as:

$$OD_\lambda = A_\lambda/l = -(1/l)\log_{10}(I_0/I)$$

where:

$l$ = the distance that light travels through the sample (sample thickness) in cm;
$A_\lambda$ = the absorbance at wavelength $\lambda$;
$I_0$ = the intensity of the incident light beam; and
$I$ = the intensity of the transmitted light beam.

Optical density is measured in ODU which is equivalent to AU/cm. When the sample thickness is 1 cm, $OD_\lambda = A_\lambda$.

In order to compare measurements from UV-vis spectra, it is necessary to normalize the absorbance measurements. The absorption spectra are normalized by dividing each absorbance curve by their respective absorbance value at a certain wavelength. Commonly, the absorbance at the first exciton peak absorption wavelength is chosen as the normalization point.

In order to normalize the optical density at a desired wavelength, the ratio of the optical density at the desired wavelength can be compared to the optical density at the first exciton peak absorption wavelength using the formula:

$$\text{Normalized } OD_\lambda = OD_\lambda/\text{peak ratio} = A_\lambda/(\text{peak ratio}* l)$$

where:

$OD_\lambda$ = optical density of the sample measured at a wavelength;
peak ratio = optical density at the first exciton peak absorption wavelength;
$A_\lambda$ = absorbance of the sample measured at a wavelength; and
$l$ = the distance that light travels through the sample (sample thickness) in cm.

For example, the normalized optical density at 450 nm can be calculated using the formula:

$$\text{Normalized } OD_{450} = OD_{450}/\text{peak ratio} = A_{450}/(\text{peak ratio}* l)$$

where:

$OD_{450}$ = optical density of the sample measured at 450 nm;
$A_{450}$ = absorbance of the sample measured at 450 nm;

peak ratio = optical density at the first exciton peak absorption wavelength; and

$l$ = the distance that light travels through the sample (sample thickness) in cm.

In some embodiments, the nanostructures have a normalized optical density at a wavelength between about 440 nm and about 495 nm of between about 1.0 and about 8.0, about 1.0 and about 6.0, about 1.0 and 3.0, about 1.0 and about 2.0, about 1.0 and about 1.8, about 1.0 and about 1.5, about 1.5 and about 8.0, about 1.5 and about 6.0, about 1.5 and about 3.0, about 1.5 and about 2.0, about 1.5 and about 1.8, about 1.8 and about 8.0, about 1.8 and about 6.0, about 1.8 and about 3.0, about 1.8 and about 2.0, about 2.0 and about 8.0, about 2.0 and about 6.0, about 2.0 and about 3.0, about 3.0 and about 8.0, about 3.0 and about 6.0, or about 6.0 and about 8.0. In some embodiments, the nanostructures of the present invention have a normalized optical density at a wavelength between about 440 nm and about 460 nm of between about 1.0 and about 8.0, about 1.0 and about 6.0, about 1.0 and 3.0, about 1.0 and about 2.0, about 1.0 and about 1.8, about 1.0 and about 1.5, about 1.5 and about 8.0, about 1.5 and about 6.0, about 1.5 and about 3.0, about 1.5 and about 2.0, about 1.5 and about 1.8, about 1.8 and about 8.0, about 1.8 and about 6.0, about 1.8 and about 3.0, about 1.8 and about 2.0, about 2.0 and about 8.0, about 2.0 and about 6.0, about 2.0 and about 3.0, about 3.0 and about 8.0, about 3.0 and about 6.0, or about 6.0 and about 8.0. In some embodiments, the nanostructures have a normalized optical density at a wavelength of about 450 nm of between about 1.0 and about 8.0, about 1.0 and about 6.0, about 1.0 and 3.0, about 1.0 and about 2.0, about 1.0 and about 1.8, about 1.0 and about 1.5, about 1.5 and about 8.0, about 1.5 and about 6.0, about 1.5 and about 3.0, about 1.5 and about 2.0, about 1.5 and about 1.8, about 1.8 and about 8.0, about 1.8 and about 6.0, about 1.8 and about 3.0, about 1.8 and about 2.0, about 2.0 and about 8.0, about 2.0 and about 6.0, about 2.0 and about 3.0, about 3.0 and about 8.0, about 3.0 and about 6.0, or about 6.0 and about 8.0. In some embodiments, provided is a method for increasing the blue light normalized absorbance of a population of nanostructures. In some embodiments, the present invention provides a method for increasing the blue light normalized optical density of a population of nanostructures.

In some embodiments, the blue light normalized optical density is increased by increasing the number of shell monolayers. In some embodiments, a shell comprising about 2 monolayers shows an increased blue light normalized optical density compared to a shell comprising between about 0.25 and about 1 monolayers. In some embodiments, a shell comprising 3 monolayers shows an increased blue light normalized optical density compared to a shell comprising between about 0.25 and about 2 monolayers, about 0.25 and about 1 monolayers, or about 1 and about 2 monolayers. In some embodiments, a shell comprising 4 monolayers shows an increased blue light normalized optical density compared to a shell comprising between about 0.25 and about 3 monolayers, about 0.25 and about 2 monolayers, about 0.25 and about 1 monolayers, about 1 and about 3 monolayers, or about 1 and about 2 monolayers. In some embodiments, a shell comprising 5 monolayers shows an increased blue light normalized optical density compared to a shell comprising between about 0.25 and about 4 monolayers, about 0.25 and about 3 monolayers, about 0.25 and about 2 monolayers, about 0.25 and about 1 monolayers, about 1 and about 4 monolayers, about 1 and about 3 monolayers, about 1 and about 2 monolayers, about 2 and about 4 monolayers, about 2 and about 3 monolayers, or about 3 and about 4 monolayers. In some embodiments, a shell comprising 6 monolayers shows an increased blue light normalized optical density compared to a shell comprising between about 0.25 and about 5 monolayers, about 0.25 and about 4 monolayers, about 0.25 and about 3 monolayers, about 0.25 and about 2 monolayers, about 0.25 and about 1 monolayers, about 1 and about 5 monolayers, about 1 and about 4 monolayers, about 1 and about 3 monolayers, about 1 and about 2 monolayers, about 2 and about 5 monolayers, about 2 and about 4 monolayers, about 2 and about 3 monolayers, about 3 and about 5 monolayers, about 3 and about 4 monolayers, or about 4 and about 5 monolayers. In some embodiments, a shell comprising 7 monolayers shows an increased blue light normalized optical density compared to a shell comprising between about 0.25 and about 6 monolayers, about 0.25 and about 5 monolayers, about 0.25 and about 4 monolayers, about 0.25 and about 3 monolayers, about 0.25 and about 2 monolayers, about 0.25 and about 1 monolayers, about 1 and about 6 monolayers, about 1 and about 5 monolayers, about 1 and about 4 monolayers, about 1 and about 3 monolayers, about 1 and about 2 monolayers, about 2 and about 6 monolayers, about 2 and about 5 monolayers, about 2 and about 4 monolayers, about 2 and about 3 monolayers, about 3 and about 6 monolayers, about 3 and about 5 monolayers, about 3 and about 4 monolayers, about 4 and about 6 monolayers, about 4 and about 5 monolayers, or about 5 and about 6 monolayers. In some embodiments, a shell comprising 8 monolayers shows an increased blue light normalized optical density compared to a shell comprising between about 0.25 and about 7 monolayers, about 0.25 and about 6 monolayers, about 0.25 and about 5 monolayers, about 0.25 and about 4 monolayers, about 0.25 and about 3 monolayers, about 0.25 and about 2 monolayers, about 0.25 and about 1 monolayers, about 1 and about 7 monolayers, about 1 and about 6 monolayers, about 1 and about 5 monolayers, about 1 and about 4 monolayers, about 1 and about 3 monolayers, about 1 and about 2 monolayers, about 2 and about 7 monolayers, about 2 and about 6 monolayers, about 2 and about 5 monolayers, about 2 and about 4 monolayers, about 2 and about 3 monolayers, about 3 and about 7 monolayers, about 3 and about 6 monolayers, about 3 and about 5 monolayers, about 3 and about 4 monolayers, about 4 and about 7 monolayers, about 4 and about 6 monolayers, about 4 and about 5 monolayers, about 5 and about 7 monolayers, about 5 and about 6 monolayers, or about 6 and about 7 monolayers.

In some embodiments, increasing the number of shell monolayers results in an increase in normalized optical density between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, increasing the number of shell monolayers results in an increase in optical density at a wavelength between about 440 nm and about 460 nm between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, increasing the number of shell monolayers results in an increase in optical density at a wavelength of about 450 nm between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0.

In some embodiments, increasing the number of ZnSe shell monolayers results in an increase in blue light normalized optical density. In some embodiments, increasing the number of ZnSe shell monolayers results in an increase in normalized optical density at a wavelength between about 440 nm and about 460 nm. In some embodiments, increasing the number of ZnSe shell monolayers results in an increase in the normalized optical density at a wavelength of about 450 nm.

In some embodiments, increasing the number of ZnSe shell monolayers results in an increase in blue light normalized optical density between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, increasing the number of ZnSe shell monolayers results in an increase in optical density at a wavelength between about 440 nm and about 460 nm of between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, increasing the number of ZnSe shell monolayers results in an increase in optical density at a wavelength of about 450 nm of between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0.

A band gap is the range in a solid where no electron state can exist. It is possible to control or alter the band gap and the resulting wavelength of a nanostructure by controlling the composition of alloys or constructing layered nanostructures with alternating compositions.

The wavelength for a nanocrystal can be determined from the bulk band gap by the following formula:

$$\text{wavelength (in nm)} = 1240.8/\text{energy (in eV)}.$$

Thus, a ZnSe nanocrystal which has a bulk band gap of 2.7 eV corresponds to a wavelength of approximately 460 nm. A ZnS nanocrystal which has a bulk band gap of 3.6 eV, corresponds to a wavelength of approximately 345 nm. And, a ZnTe nanocrystal which has a bulk band gap of 2.25 eV, corresponds to a wavelength of approximately 551 nm.

To increase the optical density at 450 nm, ZnSe can be alloyed with at least one component that has a higher band gap such as ZnS or GaN. And, to increase the optical density at 480 nm, ZnSe can be alloyed with at least one component that has a lower band gap such as AlP, CdS, GaP, ZnTe, AlAs, CdSe, AlSb, CdTe, GaAs, or InP.

To increase the optical density at 450 nm, ZnS can be alloyed with at least one component that has a lower band gap such as ZnSe, AlP, CdS, GaP, ZnTe, AlAs, CdSe, AlSb, CdTe, GaAs, or InP. And, to increase the optical density at 450 nm, ZnTe can be alloyed with at least one component that has a higher band gap such as ZnS or GaN.

In some embodiments, the component added to produce an alloy is selected from the group consisting of ZnS, GaN, ZnSe, AlP, CdS, GaP, ZnTe, AlAs, CdSe, AlSb, CdTe, GaAs, Sn, Ge, and InP.

In some embodiments, the band gap and the resulting wavelength of a nanostructure is controlled by adding a component to at least one shell monolayer to produce an alloy. In some embodiments, a component is added to produce an alloy to between about 0.25 and about 8 monolayers, about 0.25 and about 6 monolayers, about 0.25 and about 4 monolayers, about 0.25 and about 2 monolayers, about 0.25 and about 1 monolayers, about 1 and about 8 monolayers, about 1 and about 6 monolayers, about 1 and about 4 monolayers, about 1 and about 2 monolayers, about 2 and about 8 monolayers, about 2 and about 6 monolayers, about 2 and about 4 monolayers, about 4 and about 8 monolayers, about 4 and about 6 monolayers, or about 6 and about 8 monolayers.

In some embodiments, the alloy produced results in an increase in the normalized optical density of the nanostructure at a particular wavelength. In some embodiments, the alloy produced results in an increase in the blue light normalized optical density of the nanostructure. In some embodiments, the alloy produced results in an increase in the normalized optical density of the nanostructure between about 440 nm and about 460 nm. In some embodiments, the alloy produced results in an increase in the normalized optical density of the nanostructure at about 450 nm.

In some embodiments, addition of at least one component to produce an alloy results in an increase in blue light normalized optical density between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, addition of at least one component to produce an alloy results in an increase in optical density at a wavelength between about 440 nm and about 460 nm between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0. In some embodiments, addition of at least one component to produce an alloy results in an increase in optical density at a wavelength of about 450 nm between about 0.1 and about 2.0, about 0.1 and about 1.5, about 0.1 and about 1.0, about 0.1 and about 0.5, about 0.1 and about 0.3, about 0.3 and about 2.0, about 0.3 and about 1.5, about 0.3 and about 1.0, about 0.3 and about 0.5, about 0.5 and about 2.0, about 0.5 and about 1.5, about 0.5 and about 1.0, about 1.0 and about 2.0, about 1.0 and about 1.5, or about 1.5 and about 2.0.

Nanostructure Compositions

It is also disclosed a nanostructure composition comprising at least one population of nanostructures, wherein the nanostructure is a InP/ZnSe/ZnS core-shell multi-layered nanostructure wherein the thickness of at least two of the shells is between 0.7 nm and 3.5 nm.

In some embodiments, the nanostructure composition further comprises a solvent.

In some embodiments, the nanostructure is a quantum dot.

Nanostructure Layer

It is also disclosed a nanostructure layer comprising at least one population of nanostructures, wherein the nanostructure is a InP/ZnSe/ZnS core/shell multi-layered nanostructure .

The thickness of at least two of the shells is between 0.7 nm and 3.5 nm.

In some embodiments, the nanostructure is a quantum dot.

Nanostructure Molded Article

The present disclosure provides a nanostructure molded article comprising at least one population of nanostructures, wherein the nanostructure is a InP/ZnSe/ZnS core/shell multi-layered nanostructure.

The thickness of at least two of the shells is between 0.7 nm and 3.5 nm.

In some embodiments, the molded article is a film, a substrate for a display, or a light emitting diode.

In some embodiments, the nanostructure is a quantum dot.

In some embodiments, the present disclosure provides a nanostructure molded article comprising:

(a) a first barrier layer;
(b) a second barrier layer; and
(c) a nanostructure layer between the first barrier layer and the second barrier layer, wherein the nanostructure is a InP/ZnSe/ZnS multi-layered nanostructure wherein, the thickness of at least two of the shells is between 0.7 nm and 3.5 nm.

In some embodiments, the nanostructure is a quantum dot.

Making a Nanostructure Layer

In some embodiments, the nanostructure layer can be embedded in a polymeric matrix. As used herein, the term "embedded" is used to indicate that the nanostructure population is enclosed or encased with the polymer that makes up the majority of the component of the matrix. In some embodiments, at least one nanostructure population is suitably uniformly distributed throughout the matrix. In some embodiments, the at least one nanostructure population is distributed according to an application-specific distribution. In some embodiments, the nanostructures are mixed in a polymer and applied to the surface of a substrate.

In some embodiments, a nanostructure composition is deposited to form a nanostructure layer. In some embodiments, a nanostructure composition can be deposited by any suitable method known in the art, including but not limited to painting, spray coating, solvent spraying, wet coating, adhesive coating, spin coating, tape-coating, roll coating, flow coating, inkjet vapor jetting, drop casting, blade coating, mist deposition, or a combination thereof. The nanostructure composition can be coated directly onto the desired layer of a substrate. Alternatively, the nanostructure composition can be formed into a solid layer as an independent element and subsequently applied to the substrate. In some embodiments, the nanostructure composition can be deposited on one or more barrier layers.

In some embodiments, the nanostructure layer is cured after deposition. Suitable curing methods include photocuring, such as UV curing, and thermal curing. Traditional laminate film processing methods, tape-coating methods, and/or roll-to-roll fabrication methods can be employed in forming a nanostructure layer.

Spin coating

In some embodiments, the nanostructure composition is deposited onto a substrate using spin coating. In spin coating a small amount of material is typically deposited onto the center of a substrate loaded a machine called the spinner which is secured by a vacuum. A high speed of rotation is applied on the substrate through the spinner which causes centripetal force to spread the material from the center to the edge of the substrate. While most of the material would be spun off, a certain amount remains of the substrate, forming a thin film of material on the surface as the rotation continues. The final thickness of the film is determined by the nature of the deposited material and the substrate in addition to the parameters chosen for the spin process such as spin speed, acceleration, and spin time. In some embodiments, a spin speed of 1500 to 6000 rpm is used with a spin time of 10-60 seconds.

Mist Deposition

In some embodiments, the nanostructure composition is deposited onto a substrate using mist deposition. Mist deposition takes place at room temperature and atmospheric pressure and allows precise control over film thickness by changing the process conditions. During mist deposition, a liquid source material is turned into a very fine mist and carried to the deposition chamber by nitrogen gas. The mist is then drawn to the wafer surface by a high voltage potential between the field screen and the wafer holder. Once the droplets coalesce on the wafer surface, the wafer is removed from the chamber and thermally cured to allow the solvent to evaporate. The liquid precursor is a mixture of solvent and material to be deposited. It is carried to the atomizer by pressurized nitrogen gas. Price, S.C., et al., "Formation of Ultra-Thin Quantum Dot Films by Mist Deposition," ESC Transactions 77:89-94 (2007).

Spray coating

In some embodiments, the nanostructure composition is deposited onto a substrate using spray coating. The typical equipment for spray coating comprises a spray nozzle, an atomizer, a precursor solution, and a carrier gas. In the spray deposition process, a precursor solution is pulverized into micro sized drops by means of a carrier gas or by atomization (e.g., ultrasonic, air blast, or electrostatic). The droplets that come out of the atomizer are accelerated by the substrate surface through the nozzle by help of the carrier gas which is controlled and regulated as desired. Relative motion between the spray nozzle and the substrate is defined by design for the purpose of full coverage on the substrate.

In some embodiments, application of the nanostructure composition further comprises a solvent. In some embodiments, the solvent for application of the nanostructure composition is water, organic solvents, inorganic solvents, halogenated organic solvents, or mixtures thereof. Illustrative solvents include, but are not limited to, water, D2 0, acetone, ethanol, dioxane, ethyl acetate, methyl ethyl ketone, isopropanol, anisole, $\gamma$-butyrolactone, dimethylformamide, N-methylpyrroldinone, dimethylacetamide, hexamethylphosphoramide, toluene, dimethylsulfoxide, cyclopentanone, tetramethylene sulfoxide, xylene, $\varepsilon$-caprolactone, tetrahydrofuran, tetrachloroethylene, chloroform, chlorobenzene, dichlorom ethane, 1,2-dichloroethane, 1, 1,2,2-tetrachloroethane, or mixtures thereof.

In some embodiments, the nanostructure compositions are thermally cured to form the nanostructure layer. In some embodiments, the compositions are cured using UV light. In some embodiments, the nanostructure composition is coated directly onto a barrier layer of a nanostructure film, and an additional barrier layer is subsequently deposited upon the nanostructure layer to create the nanostructure film. A support substrate can be employed beneath the barrier film for added strength, stability, and coating uniformity, and to prevent material inconsistency, air bubble formation, and wrinkling or folding of the barrier layer material or other materials. Additionally, one or more barrier layers are preferably deposited over a nanostructure layer to seal the material between the top and bottom barrier layers. Suitably, the barrier layers can be deposited as a laminate film and optionally sealed or further processed, followed by incorporation of the nanostructure film into the particular lighting device. The nanostructure composition deposition process can include additional or varied components, as will be understood by persons of ordinary skill in the art. Such embodiments will allow for in-line process adjustments of the nanostructure emission characteristics, such as brightness and color (e.g., to adjust the quantum dot film white point), as well as the nanostructure film thickness and other characteristics. Additionally, these embodiments will allow for periodic testing of the nanostructure film characteristics during production, as well as any necessary toggling to achieve precise nanostructure film characteristics. Such testing and adjustments can also be accomplished without changing the mechanical configuration of the processing line, as a computer program can be employed to electronically change the respective amounts of mixtures to be used in forming a nanostructure film.

Barrier Layers

In some embodiments, the nanostructure molded article comprises one or more barrier layers disposed on either one or both sides of the nanostructure layer. Suitable barrier layers protect the nanostructure layer and the nanostructure molded article from environmental conditions such as high temperatures, oxygen, and moisture. Suitable barrier materials include non-yellowing, transparent optical materials which are hydrophobic, chemically and mechanically compatible with the nanostructure molded article, exhibit photo- and chemical-stability, and can withstand high temperatures. In some embodiments, the one or more barrier layers are index-matched to the nanostructure molded article. In some embodiments, the matrix material of the nanostructure molded article and the one or more adjacent barrier layers are index-matched to have similar refractive indices, such that most of the light transmitting through the barrier layer toward the nanostructure molded article is transmitted from the barrier layer into the nanostructure layer. This index-matching reduces optical losses at the interface between the barrier and matrix materials.

The barrier layers are suitably solid materials, and can be a cured liquid, gel, or polymer. The barrier layers can comprise flexible or non-flexible materials, depending on the particular application. Barrier layers are preferably planar layers, and can include any suitable shape and surface area configuration, depending on the particular lighting application. In some embodiments, the one or more barrier layers will be compatible with laminate film processing techniques, whereby the nanostructure layer is disposed on at least a first barrier layer, and at least a second barrier layer is disposed on the nanostructure layer on a side opposite the nanostructure layer to form the nanostructure molded article according to one embodiment. Suitable barrier materials include any suitable barrier materials known in the art. In some embodiments, suitable barrier materials include glasses, polymers, and oxides. Suitable barrier layer materials include, but are not limited to, polymers such as polyethylene terephthalate (PET); oxides such as silicon oxide, titanium oxide, or aluminum oxide (e.g., $SiO_2$, $Si_2O_3$, $TiO_2$, or $Al_2O_3$); and suitable combinations thereof. Preferably, each barrier layer of the nanostructure molded article comprises at least 2 layers comprising different materials or compositions, such that the multi-layered barrier eliminates or reduces pinhole defect alignment in the barrier layer, providing an effective barrier to oxygen and moisture penetration into the nanostructure layer. The nanostructure layer can include any suitable material or combination of materials and any suitable number of barrier layers on either or both sides of the nanostructure layer. The materials, thickness, and number of barrier layers will depend on the particular application, and will suitably be chosen to maximize barrier protection and brightness of the nanostructure layer while minimizing thickness of the nanostructure molded article. In preferred embodiments, each barrier layer comprises a laminate film, preferably a dual laminate film, wherein the thickness of each barrier layer is sufficiently thick to eliminate wrinkling in roll-to-roll or laminate manufacturing processes. The number or thickness of the barriers may further depend on legal toxicity guidelines in embodiments where the nanostructures comprise heavy metals or other toxic materials, which guidelines may require more or thicker barrier layers. Additional considerations for the barriers include cost, availability, and mechanical strength.

In some embodiments, the nanostructure film comprises two or more barrier layers adjacent each side of the nanostructure layer, for example, two or three layers on each side or two barrier layers on each side of the nanostructure layer. In some embodiments, each barrier layer comprises a thin glass sheet, e.g., glass sheets having a thickness of about 100 $\mu$m, 100 $\mu$m or less, or 50 $\mu$m or less.

Each barrier layer of the nanostructure molded article can have any suitable thickness, which will depend on the particular requirements and characteristics of the lighting device and application, as well as the individual film components such as the barrier layers and the nanostructure layer, as will be understood by persons of ordinary skill in the art. In some embodiments, each barrier layer can have a thickness of 50 $\mu$m or less, 40 $\mu$m or less, 30 $\mu$m or less, 25 $\mu$m or less, 20 $\mu$m or less, or 15 $\mu$m or less. In certain embodiments, the barrier layer comprises an oxide coating, which can comprise materials such as silicon oxide, titanium oxide, and aluminum oxide (e.g., $SiO_2$, $Si_2O_3$, $TiO_2$, or $Al_2O_3$). The oxide coating can have a thickness of about 10 $\mu$m or less, 5 $\mu$m or less, 1 $\mu$m or less, or 100 nm or less. In certain embodiments, the barrier comprises a thin oxide coating with a thickness of about 100 nm or less, 10 nm or less, 5 nm or less, or 3 nm or less. The top and/or bottom barrier can consist of the thin oxide coating, or may comprise the thin oxide coating and one or more additional material layers.

Nanostructure Layer Features and Embodiments

In some embodiments, the nanostructure layers are used to form display devices.

As used herein, a display device refers to any system with a lighting display. Such devices include, but are not limited to, devices encompassing a liquid crystal display (LCD), televisions, computers, mobile phones, smart phones, personal digital assistants (PDAs), gaming devices, electronic reading devices, digital cameras, and the like.

Nanostructure Molded Articles with Increased External Quantum Efficiency (EQE)

Light emitting diodes (LEDs) prepared using CdSe-based red quantum dots have been reported with EQEs of over 20%, which is close to the theoretical limit for efficiency with quantum dot LEDs. In contrast, LEDs prepared using InP -based quantum dots have only been reported to show EQEs of 2.3% with red quantum dots and 3.5% with green quantum dots. It is believed that this discrepancy is partially due to the quenching that InP quantum dots exhibit when deposited into close-packed films.

Similarly, while InP red quantum dots have shown solution- state quantum yields as high as about 90% - similar to the highest quantum yields shown with CdSe quantum dots - the solid-state quantum yields shown for InP red quantum dots spin coated in a film have been 20%. Comparatively, CdSe films prepared using similar techniques have shown solid-state yields of 60-70%.

In some embodiments, a molded article prepared using the nanostructures described herein shows an EQE of between about 6% and about 20%, about 6% and about 15%), about 6% and about 12%, about 6% and about 10%, about 6% and about 8%, about 6%) and about 7%, about 7% and about 20%, about 7% and about 15%, about 7% and about 12%, about 7% and about 10%, about 7% and about 8%, about 8% and about 20%, about 8% and about 15%, about 8% and about 12%, about 8% and about 10%, about 10%) and about 20%, about 10% and about 15%, about 10% and about 12%, about 12%) and about 20%, about 12% and about 15%, or about 15% and about 20%. In some embodiments, the nanostructure is a quantum dot. In some embodiments, the molded article is a light emitting diode.

In some embodiments, a molded article prepared with an increased number of ZnSe shell monolayers in the nanostructure layer results in an increase in EQE. In some embodiments, increasing the number of ZnSe shell monolayers in the nanostructures by one monolayer results in an increase in EQE of the molded article of between about 0.5% and about 3%, about 0.5% and about 2%, about 0.5% and about 1%, about 1% and about 3%), about 1%) and about 2%, or about 2% and about 3%. In some embodiments, increasing the number of ZnSe shell monolayers in the nanostructures by two monolayers results in an increase in EQE of between about 0.5% and about 4%, about 0.5% and about 3%), about 0.5% and about 2%, about 0.5% and about 1%, about 1% and about 4%, about 1%) and about 3%, about 1% and about 2%, or about 2% and about 3%. In some embodiments, the nanostructure is a quantum dot. In some embodiments, the molded article is a light emitting diode.

In some embodiments, a molded article prepared with an increased number of ZnSe shell monolayers in the nanostructures results in an increase in luminance at a voltage of 7V. In some embodiments, a molded article prepared with a population of nanostructures described herein has a luminance at 7V of between about 3000 $cd/m^2$ and about 6000 $cd/m^2$, about 3000 $cd/m^2$ and about 5000 $cd/m^2$, about 3000 $cd/m^2$ and about 4000 $cd/m^2$, about 3000 $cd/m^2$ and about 3500 $cd/m^2$, about 3500 $cd/m^2$ and about 6000 $cd/m^2$, about 3500 $cd/m^2$ and about 5000 $cd/m^2$, about 3500 $cd/m^2$ and about 4000 $cd/m^2$, about 4000 $cd/m^2$ and about 6000 $cd/m^2$, about 4000 $cd/m^2$ and about 5000 $cd/m^2$, or about 5000 $cd/m^2$ and about 6000 $cd/m^2$.

In some embodiments, a molded article prepared with an increased number of ZnSe shell monolayers in the nanostructures results in an increase in luminance at a voltage of 7V. In some embodiments, increasing the number of ZnSe shell monolayers by one monolayer in the nanostructures results in an increase of luminance at 7V of between about 5% and about 35%, about 5% and about 25%, about 5% and about 20%, about 5% and about 15%, about 5% and about 10%, about 10% and about 35%, about 10% and about 30%, about 10% and about 25%, about 10% and about 20%, about 10% and about 15%, about 15% and about 35%, about 15% and about 30%, about 15% and about 25%), about 15% and about 20%, about 20% and about 35%, about 20% and about 30%, about 20% and about 25%, about 25% and about 35%, about 25% and about 30%, or about 30% and about 35%. In some embodiments, increasing the number of ZnSe shell monolayers in the nanostructures by two monolayers results in an increase of luminance at 7V of between about 15% and about 50%, about 15%) and about 45%, about 15% and about 40%, about 15% and about 35%, about 15% and about 30%, about 20% and about 50%, about 20% and about 45%, about 20% and about 40%, about 20% and about 35%, about 20% and about 30%, about 20% and about 25%, about 20% and about 30%, about 25% and about 50%, about 25% and about 45%, about 20% and about 40%, about 30%) and about 50%, about 30%) and about 45%, about 35% and about 50%, about 35% and about 45%, about 35% and about 40%, about 40% and about 50%, about 40% and about 45%, or about 45% and about 50%. In some embodiments, the nanostructure is a quantum dot. In some embodiments, the molded article is a light emitting diode.

In some embodiments, a molded article prepared using the nanostructures described herein shows a solid-state quantum yield of between about 10% and about 50%, about 10%) and about 45%, about 10% and about 40%, about 10% and about 35%, about 10% and about 30%, about 10% and about 20%, about 20% and about 50%, about 20% and about 45%, about 20% and about 40%, about 20% and about 35%, about 20% and about 30%), about 30% and about 50%, about 30% and about 45%, about 30% and about 40%, about 30% and about 35%, about 35% and about 50%, about 35% and about 45%, about 35% and about 40%, about 40% and about 50%, about 40% and about 45%, or about 45%) and about 50%. In some embodiments, the nanostructure is a quantum dot. In some embodiments, the molded article is a light emitting diode.

In some embodiments, films prepared with an increased number of ZnSe shell monolayers in the nanostructures results in an increase in film quantum yield. In some embodiments, increasing the number of ZnSe shell monolayers in the nanostructures by one monolayers results in an increase in film quantum yield of about 3% and about 10%, about 3%) and about 8%, about 3% and about 6%, about 3% and about 5%, about 3% and about 4%), about 4% and about 10%, about 4% and about 8%, about 4% and about 6%, about 4%) and about 5%, about 5% and about 10%, about 5% and about 8%, about 5% and about 6%, about 6% and about 10%, about 6% and about 8%, or about 8% and about 10%. In some embodiments, increasing the number of ZnSe shell monolayers in the nanostructures by two monolayers results in an increase in film quantum yield of about 6%) and about 20%, about 6% and about 15%, about 6% and about 12%, about 6% and about 10%), about 6% and about 8%, about 6% and about 7%, about 7% and about 20%, about 7% and about 15%, about 7% and about 12%, about 7% and about 10%, about 7% and about 8%, about 8% and about 20%, about 8% and about 15%, about 8% and about 12%, about 8% and about 10%, about 10% and about 20%, about 10% and about 15%, about 10% and about 12%, about 12% and about 20%, about 12% and about 15%, or about 15% and about 20%.

EXAMPLES

The following examples are illustrative and non-limiting, of the products and methods described herein.

The following sets forth a series of examples that demonstrate growth of highly luminescent nanostructures.

Example 1

The deposition of a thick ZnSe/ZnS multi-layered shell on a green InP core using zinc oleate, tri-n-butylphosphine selenide, and octanethiol as precursors at temperatures exceeding 280 °C is described. Synthesis of a green InP core is disclosed in U.S. Patent Appl. Publication No. 2014/0001405.

The stoichiometry was calculated for InP cores with an absorption peak at 470 nm, a concentration in hexane of 66.32 mg/mL, and a shell thickness of 3.5 monolayers of ZnSe and 4.5 monolayers of ZnS. Zinc oleate was prepared from zinc acetate and oleic acid as a solid. TBPSe was prepared from selenium pellets and tri(«-butyl)phosphine.

To a 250 mL 3 neck round-bottom flask was added 3.48 g (5.54 mmol, 13.38 equivalents) of zinc oleate and 33.54 mL of 1-octadecene at room temperature in air. The flask was equipped with a stir bar, a rubber septum, a Schlenk adaptor, and a thermocouple. The flask was connected to a Schlenk line via a rubber hose. Inert conditions were established by at least three cycles of vacuum (<50 mtorr) and nitrogen flushing. The mixture was heated to 80 °C under nitrogen flow to afford a clear solution. The temperature was maintained and the flask was put under vacuum once again and pumped until no further gas evolution (<50 mtorr) was observed. The heating mantle was removed and the flask was allowed to cool under nitrogen flow.

When the temperature was approximately 50 °C, 0.060 g (0.41 mmol, 1.00 equivalents) of InP (diameter of the core = 17.79 Angstrom) in 0.91 mL of hexane was added. The flask was placed under vacuum cautiously and the mixture was pumped down to <50 mtorr to remove hexane. Subsequently, the reaction mixture was heated to 80 °C under nitrogen flow which afforded a clear solution. 2.52 mL (5.04 mmol, 12.16 equivalents) of tri-n-butylphosphine selenide (TBPSe) was added at approximately 100 °C. The temperature was set to 280 °C and the timer was started. A reaction temperature of 280 °C was reached after approximately 16 minutes and then held until the timer count was at 40 minutes. The heating mantle was removed and the flask was allowed to cool naturally.

When the temperature was below 100 °C, the nitrogen flow was increased to 15 standard cubic feet per hour (0.42 $m^3$/h), the septum was removed, and 16.57 g (26.38 mmol, 63.72 equivalents) of zinc oleate and 0.45 g (2.25 mmol, 5.48 equivalents) of lauric acid were added through a powder funnel. After reinserting the septum, the flask was put under vacuum carefully until no further gas evolution (<50 mtorr) is observed. The reaction mixture was heated to 280 °C under nitrogen flow for buffer layer etching and held for 15 minutes (including ramp time, timing started when the heater was started). Subsequently, the reaction flask was allowed to cool naturally. 4.16 mL (23.98 mmol, 57.93 equivalents) of octanethiol was added via a syringe at approximately 130-150 °C. The temperature was set to 300 °C and the timer was started again. The reaction temperature was reached after approximately 14 minutes and held for 50 minutes. The heating mantle was removed and the flask was allowed to cool naturally.

After the temperature of the reaction mixture was below 100 °C, the thermocouple was replaced with a glass stopper under nitrogen flow. The flask was carefully set under a slight vacuum and brought into a glove box along with two PTFE bottles. The mixture was poured into one PTFE bottle, and the flask was rinsed two times with 4 mL hexane and the rinse solutions were added to the PTFE bottle. After the mixture in the bottle cooled to room temperature, it was centrifuged at 4000 rpm for 5 minutes to separate the insoluble material. The clear but colorful supernatant was decanted into the second PTFE bottle, and 16 mL hexane was added to the first PTFE bottle to extract more quantum dot material from the insoluble side products. The first bottle was shaken and vortexed to ensure sufficient mixing, and then subjected to centrifugation at 4000 rpm for 5 minutes. The supernatant was combined with the first supernatant in the second PTFE bottle, and the now lighter insoluble wax in the first bottle was discarded. The combined supernatants were precipitated with ethanol (2 x volume, approximately 120 mL), and centrifuged at 4000 rpm for 5 minutes. The now almost colorless supernatant was discarded, and the centrifugate was redispersed in a total of 4 mL toluene (initially 2 mL, then rinsed the bottle twice with 1 mL).

During the reaction, aliquots of approximately 50 $\mu$L were taken roughly every 15 minutes for spectroscopic analysis. These aliquots were immediately quenched in 1 mL hexane, and then further diluted by adding approximately 100 $\mu$L of the sample to 4 mL hexane in a cuvette. This cuvette was subjected to absorption, fluorescence, and fluorescence excitation (at the peak emission wavelength) spectroscopy.

At the end of each step (ZnSe shell and ZnS shell) aliquots of approximately 200 were taken for TEM analysis. These were subsequently washed three times with a 1 :3 solution of hexane: ethanol in the glove box. A hexane solution with $OD_{350}$ = 0.4 is submitted for TEM analysis.

For quantum yield (QY) measurement, an aliquot of 0.5 mL was taken from the combined supernatants during work-up (or after the last reaction step during cool down) and submitted for quantum yield analysis.

Example 2

The deposition of a thick ZnSe/ZnS multi-layered shell on a green InP core using zinc oleate, tri-n-butylphosphine selenide, and octanethiol as precursors at temperatures exceeding 280 °C is described. The resultant nanostructure had a target shell thickness of 1.5 monolayers of ZnSe and 2.5 monolayers of ZnS.

To a 100 mL 4 neck round-bottom flask was added 0.409 g (0.651 mmol, 3.1 equivalents) of zinc oleate and 2 mL of 1-octadecene at room temperature in air. The flask was equipped with a glass stopper, a rubber septum, a Schlenk adaptor, and a thermocouple. The flask was connected to a Schlenk line via a rubber hose. Inert conditions were established by at least three cycles of vacuum (<50 mtorr) and nitrogen flushing. The mixture was heated to 80 °C under nitrogen flow to afford a clear solution. The temperature was maintained and the flask was put under vacuum once again and pumped until no further gas evolution (<50 mtorr) was observed. The heating mantle was removed and the flask was allowed to cool under nitrogen flow.

When the temperature was approximately 50 °C, 0.030 g (0.21 mmol, 1.00 equivalents) of InP (diameter of the cores = 18.43 Angstrom) in 0.46 mL of hexane was added. The flask was placed under vacuum and pumped down to <50 mtorr to remove hexane. Subsequently, the reaction mixture was heated to 80 °C under nitrogen flow which afforded a clear solution. 0.308 mL (0.616 mmol, 2.93 equivalents) of tri-n- butylphosphine selenide (TBPSe) was added at approximately 100 °C. The temperature was set to 280 °C and the timer was started. A reaction temperature of 280 °C was reached after approximately 16 minutes and then held until the timer count was at 40 minutes. The heating mantle was removed and the flask was allowed to cool naturally.

When the temperature was below 100 °C, the nitrogen flow was increased to 15 standard cubic feet per hour(0.42 $m^3$/h), the septum was removed, and 1.77 g (2.82 mmol, 13.41 equivalents) of zinc oleate was added through a powder funnel. After reinserting the septum, the flask was put under vacuum carefully until no further gas evolution (<50 mtorr) is observed. The reaction mixture was heated to 280 °C under nitrogen flow and held for 15 minutes (including ramp time, timing started when the heater was started). Subsequently, the reaction flask was allowed to cool naturally. 0.45 mL (2.59 mmol, 12.35 equivalents) of octanethiol was added via a syringe at approximately 130-150 °C. The temperature was set to 300 °C and the timer was started again. The reaction temperature was reached after approximately 14 minutes and held for 50 minutes. The heating mantle was removed and the flask was allowed to cool naturally.

After the temperature of the reaction mixture was below 100 °C, the thermocouple was replaced with a glass stopper under nitrogen flow. The flask was carefully set under a slight vacuum and brought into a glove box along with two PTFE bottles. The mixture was poured into one PTFE bottle, and the flask was rinsed two times with 4 mL hexane and the rinse solutions were added to the PTFE bottle. After the mixture in the bottle cooled to room temperature, it was centrifuged at 4000 rpm for 5 minutes to separate the insoluble material. The clear but colorful supernatant was decanted into the second PTFE bottle, and 16 mL hexane was added to the first PTFE bottle to extract more quantum dot material from the insoluble side products. The first bottle was shaken and vortexed to ensure sufficient mixing, and then subjected to centrifugation at 4000 rpm for 5 minutes. The supernatant was combined with the first supernatant in the second PTFE bottle, and the now lighter insoluble wax in the first bottle was discarded. The combined supernatants were precipitated with ethanol (2 x volume, approximately 120 mL), and centrifuged at 4000 rpm for 5 minutes. The now almost colorless supernatant was discarded, and the centrifugate was redispersed in a total of 4 mL toluene (initially 2 mL, then rinsed the bottle twice with 1 mL).

During the reaction, aliquots of approximately 50 μL were taken roughly every 15 minutes for spectroscopic analysis. These aliquots were immediately quenched in 1 mL hexane, and then further diluted by adding approximately 100 μL of the sample to 4 mL hexane in a cuvette. This cuvette was subjected to absorption, fluorescence, and fluorescence excitation (at the peak emission wavelength) spectroscopy.

At the end of each step (ZnSe shell and ZnS shell) aliquots of approximately 200 were taken for TEM analysis and were subsequently washed three times with a 1 :3 solution of hexane: ethanol in the glove box. A hexane solution with $OD_{350}$ = 0.4 is submitted for TEM analysis.

For quantum yield (QY) measurement, an aliquot of 0.5 mL was taken from the combined supernatants during work-up (or after the last reaction step during cool down) and submitted for quantum yield analysis.

Example 3

Nanostructures with green InP cores with a target shell thickness of 1.5 monolayers of ZnSe and (A) 4.5 monolayers of ZnS; and (B) 7.5 monolayers of ZnS were prepared using the synthetic method of Example 2 and varying the amount of zinc oleate and octanethiol added to the reaction mixture. The following amounts of zinc oleate and octanethiol precursors were used to prepare the ZnS shell:

(A) for the 4.5 monolayers of ZnS:

4.47 g of zinc oleate; and
1.13 mL of octanethiol.

(B) for the 7.5 monolayers of ZnS:

11.44 g of zinc oleate; and
2.88 mL of octanethiol.

Example 4

Nanostructures with green InP cores with a target shell thickness of 2.5 monolayers of ZnSe and (A) 2.5 monolayers of ZnS; (B) 4.5 monolayers of ZnS; and (C) 7.5 monolayers of ZnS were prepared using the synthetic method of Example 2 and varying the amount of zinc oleate, TOPSe, and octanethiol added to the reaction mixture. The following amounts of zinc oleate and TOPSe precursors were used to prepare the ZnSe shell for all three nanostructures:

0.90 g of zinc oleate; and
0.68 mL (1.92 M TOPSe).

The following amounts of zinc oleate and octanethiol precursors were used to prepare the ZnS shell:

(A) for the 2.5 monolayers of ZnS (approximately 50.33 Angstrom for the nanostructure):

2.47 g of zinc oleate;
0.62 mL of octanethiol.

(B) for the 4.5 monolayers of ZnS (approximately 62.73 Angstrom for the nanostructure):

6.91 g of zinc oleate; and
1.49 mL of octanethiol.

(C) for the 7.5 monolayers of ZnS (approximately 81.33 Angstrom for the nanostructure):

15.34 g of zinc oleate; and
3.61 mL of octanethiol.

Example 5

Nanostructures with green InP cores with a target shell thickness of 3.5 monolayers of ZnSe and (A) 4.5 monolayers of ZnS; and (B) 7.5 monolayers of ZnS were prepared using the synthetic method of Example 2 and varying the amount of zinc oleate, TBPSe, and octanethiol added to the reaction mixture. The following amounts of zinc oleate and TBPSe precursors were used to prepare the ZnSe shell for all three nanostructures:
0.97 g of zinc oleate; and 0.70 mL (2 M TBPSe).
The following amounts of zinc oleate and octanethiol precursors were used to prepare the ZnS layers:

(A) for the 4.5 monolayers of ZnS (approximately 69.29 Angstrom for the nanostructure):

4.55 g of zinc oleate; and
1.14 mL of octanethiol.

(B) for the 7.5 monolayers of ZnS (approximately 87.89 Angstrom for the nanostructure):

10.56 g of zinc oleate; and
2.65 mL of octanethiol.

Example 6

Nanostructures using red InP cores (diameter of the core = 27.24 Angstrom, 0.0581 g of InP) with 3.5 monolayers of ZnSe and 4.5 monolayers of ZnS were prepared using the synthetic method of Example 2 and varying the amount of zinc oleate, TBPSe, and octanethiol added to the reaction mixture. The following amounts of zinc oleate and TBPSe precursors were used to prepare the ZnSe shell:

1.60 of zinc oleate; and
1.16 mL (2 M TBPSe).

The following amounts of zinc oleate and octanethiol precursors were used to prepare the ZnS shell (approximately 78.10 Angstrom for the nanostructure):

6.08 g of zinc oleate; and
1.53 mL of octanethiol.

Example 7

This procedure describes the deposition of a thick $ZnSe_x Si_{-x}$ /ZnS shell on green InP cores using zinc oleate, tri-n-butylphosphine selenide (TBPSe), and octanethiol as precursors at temperatures exceeding 280 °C.
The stoichiometry is calculated for InP cores with an absorption peak at 479 nm, a concentration in hexane of 59.96 mg/mL, and a shell thickness of 3.5 monolayers of $ZnSe_x Si_{-x}$ (x = 0.5) and 4.5 monolayers of ZnS. Zinc oleate is prepared from zinc acetate and oleic acid as a solid. TBPSe is prepared from selenium pellets and tri( «- butyl)phosphine as a 2 M solution.
To a 250 mL 3 neck round-bottom flask was added 17.8 g (28.34 mmol, 69.12 equivalents) of zinc oleate, 5.68 g (28.34 mmol) of lauric acid, and 33 mL of 1- octadecene at room temperature in air. The flask was equipped with a stir bar, a rubber septum, a Schlenk adaptor, and a thermocouple. The flask was connected to a Schlenk line via a rubber hose. Inert conditions were established by at least three cycles of vacuum (<80 mtorr) and nitrogen flushing. The mixture was heated to 80 °C under nitrogen flow to afford a clear solution. The heating mantle was removed and the flask was allowed to cool under nitrogen flow.
When the temperature was approximately 100 °C, 0.060 g (0.41 mmol, 1.00 equivalents) of InP in 0.41 mL of hexane was added. The flask was placed under vacuum and was pumped down to <80 mtorr to remove hexane for 10 minutes. The temperature was set to 280 °C under nitrogen flow. 1.26 mL (2.53 mmol, 6.17 equivalents) of tri-n-butylphosphine selenide (TBPSe) and 0.44 mL (2.53 mmol, 6.17 equivalents) octanethiol were added when the temperature was approximately 100 °C. The timer was started. A reaction temperature of 280 °C was reached after approximately 16 minutes and then held until the timer count was at 80 minutes. The temperature was then set to 310 °C. 4.04 mL (23.29 mmol, 56.80 equivalents) of octanethiol was added dropwise via a syringe pump over 20 minutes. After addition of all of the octanethiol, the temperature was kept at 310 °C for 60 minutes. The heating mantle was removed and the flask allowed to cool naturally.

After the temperature of the reaction mixture was below 120 °C, the thermocouple was replaced with a glass stopper under nitrogen flow. The flask was carefully set under a slight vacuum and brought into a glove box along with one PTFE bottles. The mixture was poured into the PTFE bottle, and the flask was rinsed two times with 4 mL hexane and the rinse solutions were added to the PTFE bottle. After the mixture in the bottle cooled to room temperature, it was centrifuged at 4000 rpm for 5 minutes to separate the insoluble material. The mixture was allowed to sit overnight. The clear but colorful supernatant was decanted into a second PTFE bottle and 16-20 mL of hexane was added to the first PTFE bottle to extract more quantum dot material from the insoluble side products. The first bottle was shaken and vortexed to ensure sufficient mixing, and then subjected to centrifugation at 4000 rpm for 5 minutes. The supernatant was combined with the first supernatant in the second PTFE bottle, and the now lighter insoluble wax in the first bottle was discarded. The combined supernatants were precipitated with ethanol (2.5 x volume), and centrifuged at 4000 rpm for 5 minutes. The now almost colorless supernatant was discarded, and the centrifugate was redispersed in a total of 20 mL of hexane. The bottle was allowed to sit for approximately 15 minutes to allow additional solid to precipitate. If solid precipitated, the bottle was centrifuged at 4000 rpm for 5 minutes. The clear solution was transferred to another bottle. The solution was washed with 2.5 x volume of ethanol (50 mL) to precipitate the quantum dots. The slightly milky supernatant was discarded. 3-4 mL of toluene was added to redisperse the quantum dots. The bottle was rinsed with 2 x 1 mL of toluene.

During the reaction, aliquots of approximately 50 μL were taken roughly every 15 minutes for spectroscopic analysis. These aliquots were immediately quenched in 1 mL hexane, and then further diluted by adding approximately 100 μL of the sample to 4 mL hexane in a cuvette. This cuvette was subjected to absorption, fluorescence, and fluorescence excitation (at the peak emission wavelength) spectroscopy.

At the end of each step (ZnSe shell and ZnS shell) aliquots of approximately 200 were taken for TEM analysis. These were subsequently washed three times with a 1 :3 solution of hexane: ethanol in the glove box. A hexane solution with $OD_{350}$ = 0.4 was submitted for TEM analysis.

For quantum yield (QY) measurement, an aliquot of 0.5 MI was taken from the combined supernatants during work-up (or after the last reaction step during cool down) and submitted for quantum yield analysis.

Example 8

TABLE 1. InP/ZnSe/ZnS nanostructure

| Nanostructure | Synthetic method and selenium source | Abs (λ/nm) | Emission (λ/nm) | FWHM (nm) | Quantum Yield (%) |
|---|---|---|---|---|---|
| InP core | | 479 | | | |
| InP core 1.3 monolayers ZnSe 4.5 monolayers ZnS (not according to the invention) | low temperature | 502.0 | 535.2 | 45.6 | 81.1 |
| InP core 1.5 monolayers ZnSe 7.5 monolayers ZnS (not according to the invention) | high temperature with TOPSe | 505.8 | 536.0 | 45.8 | 47.6 |
| InP core 2.5 monolayers ZnSe 7. 5 monolayers ZnS | high temperature with TOPSe | 510.1 | 541.1 | 47.1 | 24.9 |
| InP core 3.5 monolayers ZnSe 4.5 monolayers ZnS | high temperature with TOPSe | 514.9 | 541.1 | 42.7 | 40.2 |
| InP core 3.5 monolayers ZnSe 10 monolayers ZnS | high temperature with TOPSe | 510.3 | 537.4 | 46.3 | 11.8 |

(continued)

| Nanostructure | Synthetic method and selenium source | Abs (λ/nm) | Emission (λ/nm) | FWHM (nm) | Quantum Yield (%) |
|---|---|---|---|---|---|
| InP core 3.5 monolayers ZnSe 4.5 monolayers ZnS | high temperature with TBPSe | 521.7 | 545.9 | 40.6 | 56.7 |
| InP core (enriched) 3.5 monolayers ZnSe 4.5 monolayers ZnS | high temperature with TBPSe | 529.9 | 554.4 | 40.2 | 67.9 |
| InP core (enriched) 2.5 monolayers ZnSe 4.5 monolayers ZnS | high temperature with TBPSe | 521.8 | 550.5 | 42.6 | 63.7 |
| InP core 3.5 monolayers ZnSe 4.5 monolayers ZnS | high temperature with TBPSe | 521.0 | 546.0 | 41.5 | 54.0 |

As shown in TABLE 1, using TBPSe instead of TOPSe as the selenium source resulted in an increase in red shift and an increase in quantum yield. And, as shown in TABLE 1, enriching the InP cores resulted in an increase in red shift and an increase in quantum yield.

Example 9

Nanostructures with green InP cores (457 nm absorption peak, 58 mg InP) with varying target shell thicknesses of 2.0 monolayers (not according to the invention) or 2.5 monolayers of ZnS and (A) 2.5 monolayers; (B) 3.5 monolayers; (C) 4.0 monolayers; and (D) 4.0 monolayers of ZnSe were prepared using the synthetic method of Example 2 and varying the amount of zinc oleate, TBPSe, and octanethiol that was added to the reaction mixtures.

The following amounts of zinc oleate, TBPSe, and octanethiol precursors were used to prepare a ZnSe/ZnS shell with 2.5 monolayers of ZnSe and 2.0 monolayers of ZnS (not according to the invention):

    10.3 g zinc oleate;
    0.73 mL of TBPSe (4 M); and
    1.06 mL of octanethiol.

The following amounts of zinc oleate, TBPSe, and octanethiol precursors were used to prepare a ZnSe/ZnS shell with 3.5 monolayers of ZnSe and 2.5 monolayers of ZnS:

    10.3 g zinc oleate;
    1.32 mL of TBPSe (4 M); and
    1.93 mL of octanethiol.

The following amounts of zinc oleate, TBPSe, and octanethiol precursors were used to prepare a ZnSe/ZnS shell with 4.0 monolayers of ZnSe and 2.5 monolayers of ZnS:

    12.3 g zinc oleate;

    1.71 mL of TBPSe (4 M); and

    2.20 mL of octanethiol.

The following amounts of zinc oleate, TBPSe, and octanethiol precursors were used to prepare a ZnSe/ZnS shell with 4.5 monolayers of ZnSe and 2.0 monolayers of ZnS (not according to the invention):

    12.2 g zinc oleate;

2.15 mL of TBPSe (4 M); and

1.88 mL of octanethiol.

Example 10

The nanostructures prepared in Example 9 were analyzed for their optical properties as shown in TABLE 2.

TABLE 2. Optical characterization of InP/ZnSe/ZnS nanostructures.

| Buffer Layer Structure | Absorption Peak (WL/nm) | Emission Peak (WL/nm) | FWHM (nm) | Quantum Yield | OD$_{450}$/peak ratio |
|---|---|---|---|---|---|
| 2.5 ML ZnSe | 510.8 | 538.2 | 41.4 | 84.1% | 1.00 |
| 3.5 ML ZnSe | 511.7 | 538.1 | 41.7 | 77.5% | 1.35 |
| 4.0 ML ZnSe | 511.6 | 536.8 | 40.8 | 67.5% | 1.59 |
| 4.5 ML | 511.4 | 539.3 | 42.6 | 61.8% | 1.82 |
| | | | | | |
| ZnSe | | | | | |

The increased blue light normalized absorption is measured as the ratio of optical density at 450 nm to optical density at the first exciton peak absorption wavelength. The exciton peak originates only from absorption by InP cores, while the higher energy absorption at wavelengths below 460 nm has a contribution from photon absorption in the ZnSe shell and increases with shell volume. This also means that the optical density per particle increases, e.g., by 82% when going from a 2.5 monolayer (ML) to a 4.5 ML ZnSe shell. Upon absorption in the shell the high energy shell exciton is rapidly transferred to the core and light emission occurs from a core excited state. This transfer is not quantitative as indicated by the reduced quantum yield for thicker shell materials, but the increase in absorption is relatively higher than the loss in quantum yield, so that in result more blue photons are converted to green photons by these thicker shell materials.

FIGURE 10 shows the absorption spectra of the samples with increasing ZnSe shell thickness. The spectra are normalized at the exciton peak. Therefore, the increased shell absorption is clearly visible from the absorption intensity at 450 nm.

Example 12

InP/ZnSe/ZnS red quantum dots were prepared as described in Example 2. Relative precursor quantities of zinc oleate, tri-octyl phosphine selenide (TOPSe) and dodecanethiol (DDT) were varied to control shell thickness. For example, to increase the ZnSe layer thickness from 2.5 to 4.5 monolayers, the amount of TOPSe was increased by 1.7 times. After preparing the resulting series of quantum dots with varying shell thickness, quantum dot LEDs could then be fabricated.

Example 13

Devices were prepared by a combination of spin coating and thermal evaporation. Firstly, the hole injection material poly(3,4-ethylenedioxythiophene):poly(styrene sulfonate) (PEDOT:PSS) (50 nm) was spin coated onto a UV-ozone treated indium tin oxide (ITO) substrate and baked for 15 minutes at 200 °C. The devices were transferred to an inert atmosphere and the hole transport material poly[(9,9-dioctylfluorenyl-2,7- diyl)-co-(4,4'-(N-(4-sec-butylphenyl)diphenylamine))] (TFB) (18 nm) was deposited by spin coating and baked at 135 °C for 15 minutes. A solution of either QD-1 (InP quantum dots with 2.5 monolayers of ZnSe and 4.5 monolayers of ZnS ) or QD-2 (InP quantum dots with 4.5 monolayers of ZnSe and 3 monolayers of ZnS) prepared by the method of Example 12 was deposited by spin coating, followed by spin coating of the electron transport material ZnMgO (60 nm). An Al cathode (150 nm) was then deposited by thermal evaporation followed by encapsulation of the device using a cap-glass, getter, and epoxy resin.

As shown in FIGURE 12, devices with an emissive layer composed of QD-2 exhibited higher maximum external quantum efficiency (EQE) than devices with an emissive layer composed of QD-1 (8.0% versus 6.0% EQE, respectively). Devices with an emissive layer of QD-2 also exhibited a higher luminance at 7V than devices with an emissive layer composed of QD-2 (4000 cd/m2 versus 2800 cd/m2 , respectively). Both devices showed similar current densities across a range of voltage, indicating that the thicker shell of QD-2 does not significantly hinder changer injection or transport.

Samples with the following architectures were also tested: Device- 1 (glass/TFB (20 nm)/QD-I (20 nm)/ZnMgO (60 nm)) and Device-2 (glass/TFB (20 nm)/QD-2 (20 nm)/ZnMgO (60 nm)). While QD-1 and QD-2 had similar solution state quantum yields (86% versus 89%, respectively), as shown in FIGURE 13, partial devices containing QD- 2 exhibited a significantly higher solid-state quantum yield than QD-1 (27% versus 36%, respectively). It is believed that this is a result of the increased shell thickness which increases electron and hole confinement. By increasing the spacing between cores, the thicker shell would also reduce the probability of nonradiative pathways related to energy transfer between quantum dots.

It is believed that device EQE should continue to improve with increased
ZnSe/ZnS thickness until a trade-off with charge injection or strain due to lattice mismatch is reached. Since both shell thickness and ligand length and composition affect charge injection and confinement, changing the ligand composition at the optimized new shell thickness would further improve EQE. The synthetic techniques used to control shell thickness can also be used to vary the ZnSe/ZnS composition of the shell. The resulting ZnS/ZnS gradient may also be used to improve solid-state quantum yield and result in a higher device EQE.

Example 14

Nanostructures using InP cores (diameter of the core = 27.24 Angstrom, 0.0581 g of InP) with 10.5 monolayers of ZnSe and 3 monolayers of ZnS were prepared using the synthetic method of Example 2 and varying the amount of zinc oleate, TBPSe, and octanethiol added to the reaction mixture. The following amounts of zinc oleate and TBPSe were used to prepare the ZnSe shell:

13.01 g of zinc oleate; and
9.41 mL of 2M TBPSe.

The following amounts of zinc oleate and octanethiol precursor were used to prepare the ZnS shell:

10.76 g of zinc oleate; and
2.70 mL of octanethiol.

Having now fully described this invention, it will be understood by those of ordinary skill in the art that the same can be performed within a wide and equivalent range of conditions, formulations and other parameters without affecting the scope of the invention or any embodiment thereof.

**Claims**

1. A molded article comprising InP/ZnSe/ZnS core-shell nanostructures, and wherein the thickness of at least two of the shells is between 0.7 nm and 3.5 nm.

2. The molded article of claim 1, wherein the molded article is a light emitting diode.

3. The molded article of claim 1, wherein the molded article exhibits an external quantum efficiency (EQE) of between about 6% and about 20%.

4. The molded article of claim 1, wherein the molded article exhibits an EQE of between about 8% and about 20%.

5. The molded article of claim 1, wherein the molded article has a luminance at 7 volts of between about 3000 cd/m2 and about 6000 cd/m2 .

6. The molded article of claim 1, wherein the molded article has a luminance at 7 volts of between about 3500 cd/m2 and about 4500 cd/m2 .

7. The molded article of claim 1, wherein the molded article has a solid-state quantum yield of between about 10% and about 50%.

8. The molded article of claim 1, wherein the molded article has a solid-state quantum yield of between about 30% and about 45%.

9. A nanostructure molded article comprising:

(a) a first barrier layer;
(b) a second barrier layer; and
(c) between the first barrier layer and the second barrier layer, InP/ZnSe/ZnS core-shell nanostructures, wherein the thickness of at least two of the shells is between 0.7 nm and 3.5 nm.

10. The nanostructure molded article of claim 9, further comprising a hole injection material.

11. The nanostructure molded article of claim 9, further comprising a hole injection material comprising poly(3,4-ethylenedioxythiophene):poly(styrene sulfonate).

12. The nanostructure molded article of claim 9, further comprising a hole transport material.

13. The nanostructure molded article of claim 9, further comprising a hole transport material comprising poly[(9,9-dioctylfluorenyl-2,7-diyl)-co-(4,4'-(N-(4-sec-butylphenyl)diphenylamine))] .

14. The nanostructure molded article of claim 9, further comprising an electron transport material.

15. The nanostructure molded article of claim 9, further comprising an electron transport material comprising ZnMgO.

16. The nanostructure molded article of claim 9, wherein the molded article exhibits an EQE of between about 6% and about 20%.

17. The nanostructure molded article of claim 9, wherein the molded article exhibits an EQE of between about 8% and about 20%.

18. The nanostructure molded article of claim 9, wherein the molded article has a luminance at 7 volts of between about 3000 cd/m2 and about 6000 cd/m2 .

19. The nanostructure molded article of claim 9, wherein the molded article has a luminance at 7 volts of between about 3500 cd/m2 and about 4500 cd/m2 .


**Patentansprüche**

1. Formkörper, umfassend InP/ZnSe/ZnS-Kernhüllen-Nanostrukturen, und wobei die Stärke von mindestens zwei der Hüllen zwischen 0,7 nm und 3,5 nm ist.

2. Formkörper nach Anspruch 1, wobei der Formkörper eine Leuchtdiode ist.

3. Formkörper nach Anspruch 1, wobei der Formkörper eine externe Quanteneffizienz (EQE) zwischen etwa 6 % und etwa 20 % aufweist.

4. Formkörper nach Anspruch 1, wobei der Formkörper eine EQE zwischen etwa 8 % und etwa 20 % aufweist.

5. Formkörper nach Anspruch 1, wobei der Formkörper eine Luminanz bei 7 Volt zwischen etwa 3000 cd/m2 und etwa 6000 cd/m2 aufweist.

6. Formkörper nach Anspruch 1, wobei der Formkörper eine Luminanz bei 7 Volt zwischen etwa 3500 cd/m2 und etwa 4500 cd/m2 aufweist.

7. Formkörper nach Anspruch 1, wobei der Formkörper einen Festkörper-Quantenertrag zwischen etwa 10 % und etwa 50 % aufweist.

**8.** Formkörper nach Anspruch 1, wobei der Formkörper einen Festkörper-Quantenertrag zwischen etwa 30 % und etwa 45 % aufweist.

**9.** Nanostruktur-Formkörper, umfassend:

(a) eine erste Sperrschicht;
(b) eine zweite Sperrschicht; und
(c) zwischen der ersten Sperrschicht und der zweiten Sperrschicht InP/ZnSe/ZnS-Kernhüllen-Nanostrukturen, wobei die Stärke von mindestens zwei der Hüllen zwischen 0,7 nm und 3,5 nm ist.

**10.** Nanostruktur-Formkörper nach Anspruch 9, ferner umfassend ein Lochinjektionsmaterial.

**11.** Nanostruktur-Formkörper nach Anspruch 9, ferner umfassend ein Lochinjektionsmaterial, umfassend Poly(3,4-ethylendioxythiophen):Poly(styrolsulfonat).

**12.** Nanostruktur-Formkörper nach Anspruch 9, ferner umfassend ein Lochtransportmaterial.

**13.** Nanostruktur-Formkörper nach Anspruch 9, ferner umfassend ein Lochtransportmaterial, umfassend Poly[(9,9-dioctylfluorenyl-2,7-diyl)-co-(4,4'-(N-(4-sec-butylphenyl)diphenylamin))].

**14.** Nanostruktur-Formkörper nach Anspruch 9, ferner umfassend ein Elektronentransportmaterial.

**15.** Nanostruktur-Formkörper nach Anspruch 9, ferner umfassend ein Elektronentransportmaterial, umfassend ZnMgO.

**16.** Nanostruktur-Formkörper nach Anspruch 9, wobei der Formkörper eine EQE zwischen etwa 6 % und etwa 20 % aufweist.

**17.** Nanostruktur-Formkörper nach Anspruch 9, wobei der Formkörper eine EQE zwischen etwa 8 % und etwa 20 % aufweist.

**18.** Nanostruktur-Formkörper nach Anspruch 9, wobei der Formkörper eine Luminanz bei 7 Volt zwischen etwa 3000 cd/m2 und etwa 6000 cd/m2 aufweist.

**19.** Nanostruktur-Formkörper nach Anspruch 9, wobei der Formkörper eine Luminanz bei 7 Volt zwischen etwa 3500 cd/m2 und etwa 4500 cd/m2 aufweist.

## Revendications

**1.** Article moulé comprenant des nanostructures noyau-enveloppe InP/ZnSe/ZnS, et dans lequel l'épaisseur d'au moins deux des enveloppes est comprise entre 0,7 nm et 3,5 nm.

**2.** Article moulé selon la revendication 1, dans lequel l'article moulé est une diode électroluminescente.

**3.** Article moulé selon la revendication 1, dans lequel l'article moulé présente une efficacité quantique externe (EQE) comprise entre environ 6 % et environ 20 %.

**4.** Article moulé selon la revendication 1, dans lequel l'article moulé présente une EQE comprise entre environ 8 % et environ 20 %.

**5.** Article moulé selon la revendication 1, dans lequel l'article moulé a une luminance à 7 volts comprise entre environ 3000 cd/m2 et environ 6000 cd/m2.

**6.** Article moulé selon la revendication 1, dans lequel l'article moulé a une luminance à 7 volts comprise entre environ 3500 cd/m2 et environ 4500 cd/m2.

**7.** Article moulé selon la revendication 1, dans lequel l'article moulé a un rendement quantique à l'état solide compris entre environ 10 % et environ 50 %.

8. Article moulé selon la revendication 1, dans lequel l'article moulé a un rendement quantique à l'état solide compris entre environ 30 % et environ 45 %.

9. Article moulé nanostructuré comprenant :

   (a) une première couche barrière ;
   (b) une deuxième couche barrière ; et
   (c) entre la première couche barrière et la deuxième couche barrière, des nanostructures noyau-enveloppe InP/ZnSe/ZnS, dans lequel l'épaisseur d'au moins deux des enveloppes est comprise entre 0,7 nm et 3,5 nm.

10. Article moulé nanostructuré selon la revendication 9, comprenant en outre un matériau d'injection de trous.

11. Article moulé nanostructuré selon la revendication 9, comprenant en outre un matériau d'injection de trous comprenant du poly(3,4-éthylènedioxythiophène):poly(sulfonate de styrène).

12. Article moulé nanostructuré selon la revendication 9, comprenant en outre un matériau de transport de trous.

13. Article moulé nanostructuré selon la revendication 9, comprenant en outre un matériau de transport de trous comprenant du poly(9,9-dioctylfluorényl-2,7-diyl)-co-(4,4'-(N-(4-sec-butylphényl)diphénylamine))].

14. Article moulé nanostructuré selon la revendication 9, comprenant en outre un matériau de transport d'électrons.

15. Article moulé nanostructuré selon la revendication 9, comprenant en outre un matériau de transport d'électrons comprenant du ZnMgO.

16. Article moulé nanostructuré selon la revendication 9, dans lequel l'article moulé présente une EQE comprise entre environ 6 % et environ 20 %.

17. Article moulé nanostructuré selon la revendication 9, dans lequel l'article moulé présente une EQE comprise entre environ 8 % et environ 20 %.

18. Article moulé nanostructuré selon la revendication 9, dans lequel l'article moulé a une luminance à 7 volts comprise entre environ 3000 cd/m2 et environ 6000 cd/m2.

19. Article moulé nanostructuré selon la revendication 9, dans lequel l'article moulé a une luminance à 7 volts comprise entre environ 3500 cd/m2 et environ 4500 cd/m2.

# Figure 1

Print Mag: 1080000x @ 7.0 in

20 nm

HV=120.0kV

Direct Mag: 110000x

# Figure 2

# Figure 3

Print Mag:    1080000x @ 7.0 in

30 nm

HV=120.0kV
Direct Mag: 110000x

# Figure 4

# Figure 5

# Figure 6

InP core → Add Zinc oleate (s) @ rt / TOPSe @ 80C / Heat to 280C → InP/ZnSe → Add Zinc oleate (s) @ rt / Octanethiol @ 100C / Heat to 300C → InP/ZnSe/ZnS

# Figure 7

```
┌──────────┐   Dilute in ODE          ┌──────────┐   Zinc oleate (s) @ rt    ┌──────────────┐
│ InP core │   Zinc oleate (s) @ rt   │ InP/ZnSe │   Octanethiol @ 100C      │ InP/ZnSe/ZnS │
│ (SOP)    │ ─ TBPSe @ 80C ─────────▶ │ 3.5 ML in│ ─ Heat to 300C, 50 min ─▶ │ 4.5 ML in    │
│          │   Heat to 280C, 40 min   │ one step │                           │ one step     │
└──────────┘                          └──────────┘                           └──────────────┘
```

# Figure 8

# Figure 9

# Figure 10

# Figure 12

Max EQE as a function of ZnSe, ZnS thickness

# Figure 13

Film QY vs ZnSe, ZnS layer thickness

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20140001405 A
- WO 2014209154 A
- WO 2017189666 A
- US 6225198 B
- US 6322901 B
- US 6207229 B
- US 6607829 B
- US 7060243 B
- US 7374824 B
- US 6861155 B
- US 7125605 B
- US 7566476 B
- US 8158193 B
- US 8101234 B
- US 20110262752
- US 20110263062 A
- US 5505928 A
- US 6306736 B
- US 6576291 B
- US 6788453 B
- US 6821337 B
- US 7138098 B
- US 7557028 B
- US 8062967 B
- US 7645397 B
- US 8282412 B
- US 2015236195
- US 7572395 B
- US 8143703 B
- US 8425803 B
- US 8563133 B
- US 8916064 B
- US 9005480 B
- US 9139770 B
- US 9169435 B
- US 20080118755
- US 7068898 B
- US 20100276638
- US 20070034833 A
- US 20120113672 A
- US 20080237540 A
- US 20100110728 A
- US 20100155749 A
- US 7374807 B
- US 6501091 B
- US 6803719 B
- US 20140001405

**Non-patent literature cited in the description**

- **WANG, A. et al.** *Nanoscale,* 2015, vol. 7, 2951-2959
- **CHIBLI, H. et al.** Cytotoxicity of InP/ZnS quantum dots related to reactive oxygen species generation. *Nanoscale,* 2011, vol. 3, 2552-2559
- **BLACKBURN, J.L. et al.** Electron and Hole Transfer from Indium Phosphide Quantum Dots. *J. Phys. Chem. B,* 2005, vol. 709, 2625-2631
- **SEIMARTEN, D. et al.** Quenching of Semiconductor Quantum Dot Photoluminescence by a $\pi$-Conjugated Polymer. *J. Phys. Chem. B,* 2005, vol. 709, 15927-15933
- **ZIEGLER, J. et al.** *Adv. Mater.,* 2008, vol. 20, 4068-4073
- **JO, J.-H. et al.** *J. Alloys Compd.,* 2015, vol. 647, 6-13
- **LI, J. J. et al.** *J. Am. Chem. Soc.,* 2003, vol. 725, 12567-12575
- **LI, J.J. et al.** *J. Am. Chem. Soc.,* 2003, vol. 725, 12567-12575
- **ITHURRIA, S. et al.** *J. Am. Chem. Soc.,* 2012, vol. 134, 18585-18590
- *Jouranl of Information Display,* June 2012, vol. 13 (2), 91-95
- **WELLS, R.L. et al.** The use of tris(trimethylsilyl)arsine to prepare gallium arsenide and indium arsenide. *Chem. Mater.,* 1989, vol. 7, 4-6
- **GUZELIAN, A. A. et al.** Colloidal chemical synthesis and characterization of InAs nanocrystal quantum dots. *Appl. Phys. Lett.,* 1996, vol. 69, 1432-1434
- **XIE, R et al.** Colloidal InP nanocrystals as efficient emitters covering blue to near-infrared. *J. Am. Chem. Soc.,* 2007, vol. 729, 15432-15433
- **MICIC, O.I. et al.** Core-shell quantum dots of lattice-matched ZnCdSe2 shells on InP cores: Experiment and theory. *J. Phys. Chem. B,* 2000, vol. 104, 12149-12156
- **LIU, Z. et al.** Coreduction colloidal synthesis of III-V nanocrystals: The case of InP. *Angew. Chem. Int. Ed. Engl.,* 2008, vol. 7, 3540-3542

- **LI, L. et al.** Economic synthesis of high quality InP nanocrystals using calcium phosphide as the phosphorus precursor. *Chem. Mater.,* 2008, vol. 20, 2621-2623
- **D. BATTAGLIA ; X. PENG.** Formation of high quality InP and InAs nanocrystals in a noncoordinating solvent. *Nemo Letters,* 2002, vol. 2, 1027-1030
- **KIM, S. et al.** Highly luminescent InP/GaP/ZnS nanocrystals and their application to white light-emitting diodes. *J. Am. Chem. Soc.,* 2012, vol. 734, 3804-3809
- **NANN, T. et al.** Water splitting by visible light: A nanophotocathode for hydrogen production. *Angew. Chem. Int. Ed.,* 2010, vol. 9, 1574-1577
- **BORCHERT, H et al.** Investigation of ZnS passivated InP nanocrystals by XPS. *Nano Letters,* 2002, vol. 2, 151-154
- **L. LI ; P. REISS.** One-pot synthesis of highly luminescent InP/ZnS nanocrystals without precursor injection. *J. Am. Chem. Soc.,* 2008, vol. 730, 11588-11589
- **HUSSAIN, S. et al.** One-pot fabrication of high-quality InP/ZnS (core/shell) quantum dots and their application to cellular imaging. *Chemphyschem. JO,* 2009, A466-1410
- **XU, S. et al.** Rapid synthesis of high-quality InP nanocrystals. *J. Am. Chem. Soc.,* 2006, vol. 725, 1054-1055
- **MICIC, O.I. et al.** Size-dependent spectroscopy of InP quantum dots. *J. Phys. Chem. B,* 1997, vol. 707, 4904-4912
- **HAUBOLD, S. et al.** Strongly luminescent InP/ZnS core-shell nanoparticles. *Chemphyschem.,* 2001, vol. 5, 331-334
- **CROSGAGNEUX, A et al.** Surface chemistry of InP quantum dots: A comprehensive study. *J. Am. Chem. Soc.,* 2010, vol. 732, 18147-18157
- **MICIC, O.I et al.** Synthesis and characterization of InP, GaP, and GaInP2 quantum dots. *J. Phys. Chem.,* 1995, vol. 99, 7754-7759
- **GUZELIAN, A.A. et al.** Synthesis of size-selected, surface- passivated InP nanocrystals. *J. Phys. Chem.,* 1996, vol. 700, 7212-7219
- **LUCEY, D.W. et al.** Monodispersed InP quantum dots prepared by colloidal chemistry in a non-coordinating solvent. *Chem. Mater.,* 2005, vol. 77, 3754-3762
- **LIM et al.** InP@ZnSeS, core@composition gradient shell quantum dots with enhanced stability. *Chem. Mater.,* 2011, vol. 23, 4459-4463
- **ZAN, F. et al.** Experimental studies on blinking behavior of single InP/ZnS quantum dots: Effects of synthetic conditions and UV irradiation. *J. Phys. Chem. C,* 2012, vol. 77 (5), 394-3950
- **JO, J.-H. et al.** *J. Alloys & Compounds,* 2015, vol. 647, 6-13
- Size Effects on Semiconductor Nanoparticles. **KOOLE, R.** Nanopar -tides. Springer-Verlag, 2014, 13-50
- **ZHAO, H. et al.** *Small,* 2016, vol. 72, 5354-5365
- **I. COROPCEANU ; M.G. BAWENDI.** *Nano Lett.,* 2014, vol. 14, 4097-4101
- **PRICE, S.C et al.** Formation of Ultra-Thin Quantum Dot Films by Mist Deposition. *ESC Transactions,* 2007, vol. 77, 89-94